(19) Europäisches Patentamt
European Patent Office
Office européen des brevets

(11) EP 2 360 738 A1

(12) # EUROPEAN PATENT APPLICATION
published in accordance with Art. 153(4) EPC

(43) Date of publication:
**24.08.2011 Bulletin 2011/34**

(21) Application number: **09833336.2**

(22) Date of filing: **03.12.2009**

(51) Int Cl.:
***H01L 31/042*** *(2006.01)*

(86) International application number:
**PCT/JP2009/070347**

(87) International publication number:
**WO 2010/071032 (24.06.2010 Gazette 2010/25)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **16.12.2008 JP 2008320160**
**16.12.2008 JP 2008320161**
**28.01.2009 JP 2009017337**
**28.01.2009 JP 2009017338**

(71) Applicant: **Techno Polymer Co., Ltd.**
**Minato-ku**
**Tokyo 105-0021 (JP)**

(72) Inventors:
- **WATANABE ATSUSHI**
  **Tokyo 105-0021 (JP)**
- **HASHIMOTO Masanori**
  **Tokyo 105-0021 (JP)**

(74) Representative: **TBK**
**Bavariaring 4-6**
**80336 München (DE)**

(54) **SOLAR CELL BACKSHEET AND SOLAR CELL MODULE PROVIDED WITH SAME**

(57) The present backsheet for solar cell (1) is provided with a first resin layer (11), second resin layer (12), third resin layer (13) and fourth resin layer (14). The first resin layer (11) is an infrared transmissible colored resin layer, second resin layer (12) is a white-based resin layer, and fourth resin layer (14) is a back surface protective layer. Thickness ($H_A$) of the first resin layer (11), thickness ($H_B$) of the second resin layer (12), and thickness ($H_C$) of the third resin layer (13) satisfy equations (1) : $0.4 \leqq (H_A+H_C)/H_B \leqq 2.4$ and (2) : $0.7 \leqq H_A/H_C \leqq 1.3$. A water vapor barrier layer may be provided between the third resin layer (13) and fourth resin layer (14).

FIG. 1

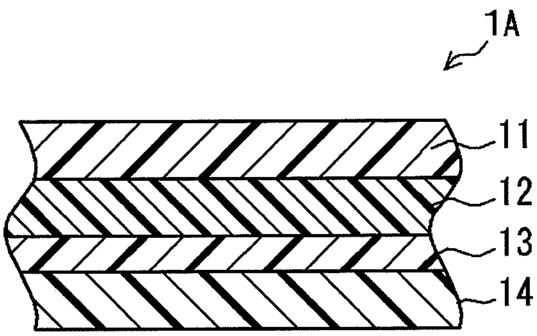


EP 2 360 738 A1

## Description

[Technical Field]

The present invention relates to a backsheet for solar cell which has a dark-colored external appearance, which has a property to absorb visible light therein, transmit an infrared light therethrough upon irradiation of light thereto and prevent heat storage, which is capable of improving a photoelectric conversion efficiency, and which is excellent in flexibility, heat resistance and scratch resistance, a backsheet for solar cell which is excellent in flexibility, heat resistance, water vapor barrier property and scratch resistance, and a solar cell module having the backsheet for solar cell.

[Background Art]

Recently, emphasized attention has been directed to a solar cell as energy supplying means, instead of petroleum as an energy source tending to generate carbon dioxide leading to global warming. Demands for solar cells have also been increased, in a manner to demand stable supply and decreased costs of various members for constituting a solar cell module to be included in a solar cell. Further, demand has also been enhanced, for improvement of a power generation efficiency of the solar cell.
The solar cell module is configured: to include numerous plate-like solar cell elements arranged to be mutually serially or parallelly wired; and to be packaged into a unit so as to protect the elements. Further, such a solar cell module is typically structured to have a surface on which a solar light impinges and which is covered by a glass plate, in an exemplary manner that gaps of solar cell elements are filled with a composition containing an ethylene vinyl acetate copolymer or the like which is high in transparency and excellent in moisture resistance to thereby form a filling unit; and then a back surface (an exposed surface of the filling unit) is sealed with a member called backsheet for solar cell.
Known as the backsheet for solar cell, is one in which white colored thermoplastic resin sheets laminated on both surfaces of a polyester sheet in order to enhance a reflectivity to solar light, thereby improving a power generation efficiency of a solar cell (See Patent Documents 1 and 2).
In the case of arranging a solar cell on a roof of a house or the like, it is preferable for solar cell to be colored in a dark color from a standpoint of external appearance, and as such, a backsheet for solar cell colored in a dark color has been demanded.
A typical example of a dark-colored backsheet is one adopting carbon black. However, this type of configuration has been likely to be subjected to a temperature elevation due to absorption of solar light by the carbon black, thereby not only deteriorating a power generation efficiency of an associated solar cell, but also deteriorating the durability thereof. Further, known as another type of a backsheet is a sheet obtained using a low heat-storage resin composition containing a thermoplastic resin and an inorganic pigment having an infrared reflecting property (See Patent Document 3).
Additionally known is a backsheet, which has a black resin layer containing a perylene-based pigment at a surface of the backsheet, and which has a reflectivity of 30% or more against a light having a wavelength between 800nm and 1,100nm in a manner to reflect a near infrared light, thereby preventing heat storage (See Patent Document 4).
Moreover, in a solar cell module having a backsheet for solar cell, it has been occasional that invasion of water, water vapor, or the like thereinto from a backsheet side brings about degradation of solar cell elements, as well as deterioration of power generation efficiency.

[Prior Art Documents]

[Patent Document]

Patent Document 1: JP-A 2006-270025
Patent Document 2: JP-A 2007-177136
Patent Document 3: JP-A 2007-103813
Patent Document 4: JP-A 2007-128943

[Summary of the Invention]

[Problems to be solved by the Invention]

It is an object of the present invention to provide a backsheet for solar cell which has a dark-colored external appearance, which is excellent in balance between flexibility and heat resistance (dimension stability), and excellent in

design and scratch resistance, which transmits an infrared light therethrough to prevent heat storage, and which is capable of improving a photoelectric conversion efficiency, and a solar cell module having the backsheet for solar cell. It is another object of the present invention to provide a backsheet for solar cell which has a dark-colored external appearance, which is excellent in balance between flexibility and heat resistance (dimension stability), and excellent in design, water vapor barrier property and scratch resistance, which transmits an infrared light therethrough to prevent heat storage, and which is capable of improving a photoelectric conversion efficiency, and a solar cell module having the backsheet for solar cell.

[Means for solving problems]

The present invention is as follows.

1. A backsheet for solar cell comprising a first resin layer, a second resin layer, a third resin layer, and a fourth resin layer, sequentially, characterized in that the first resin layer is an infrared transmissible colored resin layer, that at least the second resin layer, of the second resin layer and the third resin layer, is a white-based resin layer, that the fourth resin layer is a back surface protective layer, and that a thickness ($H_A$) of the first resin layer, a thickness ($H_B$) of the second resin layer, and a thickness ($H_C$) of the third resin layer satisfy the following equations (1) and (2).

$$0.4 \leqq (H_A+H_C)/H_B \leqq 2.4 \qquad (1)$$

$$0.7 \leqq H_A/H_C \leqq 1.3 \qquad (2)$$

2. The backsheet for solar cell according to 1 above,
wherein a thermoplastic resin constituting the first resin layer, a thermoplastic resin constituting the second resin layer, and a thermoplastic resin constituting the third resin layer each contain an aromatic vinyl-based resin.
3. The backsheet for solar cell according to 2 above,
wherein both a glass transition temperature of the thermoplastic resin constituting the first resin layer and a glass transition temperature of the thermoplastic resin constituting the third resin layer are lower than a glass transition temperature of the thermoplastic resin constituting the second resin layer.
4. The backsheet for solar cell according to any one of 1 to 3 above,
wherein the backsheet has an absorbance of a light having a wavelength of 400 to 700 nm of 60% or higher when the light is irradiated to a surface of the first resin layer of the backsheet for solar cell.
5. The backsheet for solar cell according to any one of 1 to 4 above,
wherein the backsheet has a reflectance to a light having a wavelength of 800 to 1,400 nm of 50% or higher when the light is irradiated to a surface of the first resin layer of the backsheet for solar cell.
6. The backsheet for solar cell according to any one of 1 to 5 above,
wherein the fourth resin layer is a layer having flame resistance.
7. The backsheet for solar cell according to any one of 1 to 6 above, further comprising a water vapor barrier layer between the third resin layer and the fourth resin layer.
8. The backsheet for solar cell according to 7 above,
wherein the water vapor barrier layer is consisting of a vapor deposited film in which a layer of a metal and/or a metal oxide is formed thereon.
9. The backsheet for solar cell according to 7 or 8 above,
wherein an adhesive layer is provided between the third resin layer and/or the fourth resin layer, and the water vapor barrier layer.
10. The backsheet for solar cell according to any one of 1 to 9 above, having a dimension change ratio of ±1% or less when the backsheet for solar cell is left to stand still at a temperature of 150°C for 30 minutes.
11. The backsheet for solar cell according to any one of 1 to 10 above, wherein a thickness of the backsheet for solar cell is in the range from 50 to 1,000 μm.
12. A solar cell module, characterized by comprising the backsheet for solar cell according to any one of 1 to 11 above.

[Effect of the Invention]

The backsheet for solar cell of the present invention is excellent in balance between flexibility and heat resistance (dimension stability), and in design and scratch resistance, and the first resin layer transmits an infrared light therethrough to prevent heat storage, thereby improving a photoelectric conversion efficiency.
Additionally, the backsheet for solar cell of the present invention having a water vapor barrier layer between the third and fourth resin layers is excellent in balance between flexibility and heat resistance (dimension stability), and in design,

water vapor barrier property and scratch resistance, and the first resin layer transmits an infrared light therethrough to prevent heat storage, thereby improving a photoelectric conversion efficiency.
In the case where a thermoplastic resin constituting the first resin layer, a thermoplastic resin constituting the second resin layer, and a thermoplastic resin constituting the third resin layer each contain an aromatic vinyl-based resin, hydrolysis resistance, dimensional stability, impact resistance, and the like are excellent.
In the case where both a glass transition temperature of the thermoplastic resin constituting the first resin layer and a glass transition temperature of the thermoplastic resin constituting the third resin layer are lower than a glass transition temperature of the thermoplastic resin constituting the second resin layer, occurrence of cracks or the like can be suppressed upon folding of the backsheet, thereby achieving a balance between heat resistance and flexibility.
In the case where the backsheet has an absorbance of a light having a wavelength of 400 to 700 nm of 60% or higher when the light is irradiated to a surface of the first resin layer of the backsheet for solar cell, a solar cell module having an excellent dark-colored external appearance can be provided. When the solar cell module having the sheet is arranged on a roof of a house or the like, excellent external appearance, design and the like can be obtained.
In the case where the backsheet has a reflectance to a light having a wavelength of 800 to 1,400 nm of 50% or higher when the light is irradiated to a surface of the first resin layer of the backsheet for solar cell, a heat storage in the backsheet for solar cell is restricted when the solar light transmits through a filling unit which contains an ethylene vinyl acetate copolymer composition or the like for embedding solar cell elements therein and leaks through gaps among adjacent solar cell elements toward the backsheet for solar cell. And the reflected light is supplied to the back surfaces of the solar cell elements to improve a power generation efficiency.
In the case where the water vapor barrier layer is consisting of a vapor deposited film in which a layer of a metal and/or a metal oxide is formed thereon, water vapor barrier property is excellent without deteriorating a balance between flexibility and heat resistance (dimension stability).
In the case where the backsheet for solar cell of the present invention has a dimension change ratio of $\pm 1\%$ or less when the backsheet is left to stand still at a temperature of 150°C for 30 minutes, heat resistance is excellent.
In the case where the thickness of the backsheet for solar cell of the present invention is in the range from 50 to 1,000 $\mu$m, flexibility is excellent.
The solar cell module of the present invention is excellent in external appearance, design, heat resistance, weather resistance, and scratch resistance due to the backsheet for solar cell of the present invention, and leads to a formation of a solar cell which improves a photoelectric conversion efficiency. The solar cell is suitable for outdoor usage where the backsheet is exposed to sunlight, wind and rain, and the like over a long period of time.

[Brief Description of the Drawings]

Fig. 1 is a cross-sectional view of an example of a backsheet for solar cell;
Fig. 2 is a cross-sectional view of another example of a backsheet for solar cell;
and
Fig. 3 is a cross-sectional view of an example of a solar cell module of the present invention.

[Description of the Preferred Embodiments]

Hereinafter, the present invention will be described in greater detail. In the present specification, "(co)polymer (ize)" means homopolymer(ize) and copolymer(ize), "(meth)acryl" means acryl and methacryl, and "(meth)acrylate" means acrylate and methacrylate.
The backsheet for solar cell of the present invention is one having a first resin layer, a second resin layer, a third resin layer, and a fourth resin layer, sequentially. The schematic cross section is shown in Fig. 1. The backsheet for solar cell 1A of Fig. 1 is a multi-layer type sheet having a first resin layer 11, a second resin layer 12, a third resin layer 13, and a fourth resin layer 14, sequentially.
The backsheet for solar cell of the present invention may have a water vapor barrier layer between the third resin layer and fourth resin layer. The schematic cross section is shown in Fig. 2. The backsheet for solar cell 1B of Fig. 2 is a multi-layer type sheet having a first resin layer 11, a second resin layer 12, a third resin layer 13, a water vapor barrier layer 15, and a fourth resin layer 14, sequentially.
The backsheet for solar cell of the present invention is used for adhesion between a surface (upper surface side) of the first resin layer 11 and an exposed surface of the filling unit which contains an ethylene vinyl acetate copolymer composition or the like for embedding solar cell elements.
The first resin layer is an infrared transmissible colored resin layer to be joined to an exposed surface of a filling unit which embeds solar cell elements therein, and is preferably a layer obtained using a thermoplastic resin composition

(hereinafter, referred to as "first thermoplastic resin composition") containing a thermoplastic resin (hereinafter, referred to as "thermoplastic resin (I)") and a coloring agent (hereinafter, referred to as "infrared transmissible coloring agent") having a property to absorb a visible light therein and to transmit an infrared light therethrough. Further, this first resin layer is a layer which acts to transmit an infrared light therethrough, to absorb a visible light therein to thereby exhibit coloration, and to provide the backsheet with flexibility, in the backsheet for solar cell of the present invention.
The second resin layer is a white-based resin layer, and is preferably a layer obtained using a thermoplastic resin composition (hereinafter, referred to as "second thermoplastic resin composition") containing a thermoplastic resin (hereinafter, referred to as "thermoplastic resin (II)") and a coloring agent (hereinafter, referred to as "white-based coloring agent") having a property to reflect a visible light, an infrared light, and the like. Further, this second resin layer is a base layer in the backsheet for solar cell of the present invention, has a heat resistance and possesses a function to reflect an infrared light having transmitted through the first resin layer.
The third resin layer is preferably a layer obtained using a thermoplastic resin composition (hereinafter, referred to as "third thermoplastic resin composition") containing a thermoplastic resin (hereinafter, referred to as "thermoplastic resin (III)"). Further, this third resin layer is a layer which provides the backsheet for solar cell of the present invention with flexibility. It is noted that, when the third resin layer contains a white-based coloring agent, it is allowed to reflect an infrared light by the third resin layer even when the infrared light has transmitted through the second resin layer.
Further, the fourth resin layer is a back surface protective layer, and is preferably a layer obtained using a thermoplastic resin composition (hereinafter, referred to as "fourth thermoplastic resin composition") containing a thermoplastic resin (hereinafter, referred to as "thermoplastic resin (IV)"). Moreover, this fourth resin layer is a layer having a function to restrict a damage, deterioration and the like of the backsheet for solar cell of the present invention to be otherwise caused by an impact due to a force, a heat, a chemical substance, and the like from the reverse surface of the backsheet, thereby allowing a solar cell module provided with the backsheet for solar cell to possess durability and the like.
The backsheet for solar cell of the present invention may have a water vapor barrier layer, as described above. In this case, it is possible to protect the water vapor barrier layer mainly by the fourth resin layer, in a manner to restrict a damage, deterioration, and the like of the water vapor barrier layer to be otherwise caused by an impact due to a force, a heat, a chemical substance, and the like from the reverse surface of the water vapor barrier layer, thereby allowing a solar cell module provided with the backsheet for solar cell to possess durability and the like.
The first thermoplastic resin composition, second thermoplastic resin composition, third thermoplastic resin composition and fourth thermoplastic resin composition are each preferably a composition capable of forming a film.
The thermoplastic resin (I) contained in the first thermoplastic resin composition has a glass transition temperature (hereinafter, referred to as "Tg") of preferably between 90°C and 200°C, more preferably between 95°C and 180°C, further preferably between 100°C and 170°C, and particularly between 105°C and 160°C, from a viewpoint of providing the backsheet for solar cell of the present invention with flexibility.
The thermoplastic resin (II) contained in the second thermoplastic resin composition has a Tg of preferably between 110°C and 220°C, more preferably between 120°C and 200°C, and further preferably between 130°C and 190°C, from a viewpoint of providing the backsheet for solar cell of the present invention with heat resistance. In addition, the thermoplastic resin (III) contained in the third thermoplastic resin composition has a Tg of preferably between 90°C and 200°C, more preferably between 95°C and 180°C, further preferably between 100°C and 170°C, and particularly between 105°C and 160°C from a viewpoint of providing the backsheet for solar cell of the present invention with flexibility.
The Tg can be measured with a differential scanning spectrometer (DSC) .
In the backsheet for solar cell of the present invention, the preferable configuration for obtaining an improved heat resistance and improved flexibility is as follows. Namely, Tg of the thermoplastic resin (I) and Tg of the thermoplastic resin (III) are to be equal to or lower than Tg of the thermoplastic resin (II). To provide the backsheet with a sufficient flexibility, it is preferable that Tg of the thermoplastic resin (I) and Tg of the thermoplastic resin (III) are lower than Tg of the thermoplastic resin (II). The difference between Tg of the thermoplastic resin (I) and Tg of the thermoplastic resin (II) is preferably 10°C or more, an more preferably 15°C or more. The difference between Tg of the thermoplastic resin (II) and Tg of the thermoplastic resin (III) is preferably 10°C or more, an more preferably 15°C or more.
When plural Tg are obtained on a DSC curve because two or more kinds of thermoplastic resins are contained in each resin layer, the even higher Tg is to be adopted as the applicable one.
Hereinafter, each layer will be described in sequence.
The thermoplastic resin (I) contained in the first thermoplastic resin composition which forms the first resin layer (infrared transmissible colored resin layer) is not particularly limited so long as it has a thermoplasticity. Examples of the thermoplastic resin (I) constituting the first resin layer include an aromatic vinyl-based resin, a polyolefin resin, a poly vinyl chloride resin, a poly vinylidene chloride resin, a poly vinyl acetate resin, a saturated polyester resin, a polycarbonate resin, an acrylic resin such as a (co)polymer using a (meth)acrylic acid ester compound, a fluorine resin, an ethylene vinyl acetate-based resin, and the like. These resins may be used singly or in combination of two or more types thereof. Among these, an aromatic vinyl-based resin is preferable from viewpoints of hydrolysis resistance and dimension stability.
Examples of the aromatic vinyl-based resin include a rubber reinforced aromatic vinyl-based resin obtained by

polymerizing an aromatic vinyl compound and the like in the presence of a rubbery polymer; a (co)polymer obtained using a vinyl-based monomer including an aromatic vinyl compound, such as an acrylonitrile styrene copolymer; and the like. In the present invention, the aromatic vinyl-based resin is preferably a rubber reinforced aromatic vinyl-based resin. When the thermoplastic resin (I) contains a rubber reinforced aromatic vinyl-based resin, a first resin layer excellent in hydrolysis resistance, dimension stability and impact resistance can be formed.

Examples of the aromatic vinyl-based resin include: a rubber reinforced aromatic vinyl-based resin (I-1) obtained by polymerizing a vinyl-based monomer (b11) containing an aromatic vinyl compound in the presence of a rubbery polymer (a11); a (co)polymer (I-2) of a vinyl-based monomer (b12) containing an aromatic vinyl compound; and a mixture of the rubber reinforced aromatic vinyl-based resin (I-1) and the (co)polymer (I-2) .

The rubber reinforced aromatic vinyl-based resin (I-1) usually contains therein a copolymerized resin where the vinyl-based monomer (b11) containing the aromatic vinyl compound is graft copolymerized to the rubbery polymer (a11) and an ungrafted component where the vinyl-based monomer is not grafted to the rubbery polymer (a11), i.e., a (co)polymer derived from the remaining vinyl-based monomer (b11).

As described above, the aromatic vinyl-based resin preferably contains at least one kind of the rubber reinforced aromatic vinyl-based resin (I-1). It is particularly preferable that one or more kinds of the rubber reinforced aromatic vinyl-based resins (I-1), or a combination of one or more kinds of the rubber reinforced aromatic vinyl-based resins (I-1) and one or more kinds of the (co)polymers (I-2) is used. In these cases, the content of the rubbery polymer (a11) in the aromatic vinyl-based resin is preferably in the range from 5% to 40% by mass, more preferably from 8% to 30% by mass, further preferably from 10% to 20% by mass, and particularly from 12% to 18% by mass based on 100% by mass of the thermoplastic resin (I) containing the aromatic vinyl-based resin. If the content is exceeding 40% by mass, heat resistance may not be sufficient and a formation of the first resin layer using the first thermoplastic resin composition may be difficult. On the other hand, if the content is less than 5% by mass, flexibility may not be sufficient.

The rubbery polymer (a11) used for the formation of the rubber reinforced aromatic vinyl-based resin (I-1) is not particularly limited so long as it is rubbery at room temperature. The polymer may be a homopolymer or a copolymer. In addition, this rubbery polymer (a11) may be a crosslinked polymer or a non-crosslinked polymer.

The rubery polymer (a11) is not particularly limited and example thereof includes a conjugated diene-based rubber, a hydrogenated conjugated diene-based rubber, an ethylene α-olefin-based copolymeric rubber, an acrylic rubber, a silicone rubber, a silicone-acryl composite rubber, and the like. These rubbers may be used singly or in combination of two or more types thereof.

Among these, a conjugated diene-based rubber is preferable from a viewpoint of impact resistance, and an acrylic rubber, silicone rubber, silicone-acryl composite rubber, ethylene α-olefin-based copolymeric rubber, and hydrogenated conjugated diene-based rubber are preferable from a viewpoint of weather resistance.

The rubbery polymer (a11) is not particularly limited in shape, and may be in a particulate shape (spherical shape, or substantially spherical shape), linear shape, curved shape, or the like. In the case of a particulate shape, its volume average particle size is preferably in the range from 5 to 2,000 nm, more preferably in the range from 10 to 1,800 nm, and further preferably in the range from 50 to 1,500 nm. Volume average particle size within the above range leads to an improved processability of the first thermoplastic resin composition, an excellent impact resistance of first resin layer to be obtained therefrom, and the like. The volume average particle size can be measured by an image analyzing method utilizing an electron photomicrograph, a laser diffraction method, a light scattering method, and the like.

Examples of the conjugated diene-based rubber include a polybutadiene, a butadiene styrene random copolymer, a butadiene styrene block copolymer, a butadiene acrylonitrile copolymer, and the like. These polymers may be used singly or in combination of two or more types thereof.

In the present invention, the conjugated diene-based rubber is to preferably have a glass transition temperature of -20°C or lower, from viewpoints of flexibility, low-temperature impact resistance, and the like.

The acrylic rubber is preferably a (co)polymer containing a structural unit derived from an alkyl acrylate having an alkyl group with 2 to 8 carbon atoms, in an amount of 80% or more by mass, based on the total amount of structural units constituting the acrylic rubber.

Examples of the alkyl acrylate having an alkyl group with 2 to 8 carbon atoms include ethyl acrylate, propyl acrylate, n-butyl acrylate, isobutyl acrylate, hexyl acrylate, n-octyl acrylate, 2-ethylhexyl acrylate, and the like. These compounds may be used singly or in combination of two or more types thereof. Preferable alkyl acrylates are n-butyl acrylate, isobutyl acrylate and 2-ethylhexyl acrylate.

When the acrylic rubber contains structural units derived from other monomers, examples of the other monomers include: a monofunctional monomer such as vinyl chloride, vinylidene chloride, acrylonitrile, a vinyl ester, a methacrylic acid alkyl ester, (meth)acrylic acid and styrene; a crosslinkable monomer such as a mono- or poly-ethylene glycol di (meth)acrylate including ethylene glycol di(meth)acrylate, diethylene glycol di(meth)acrylate, triethylene glycol di(meth) acrylate, and tetraethylene glycol di(meth)acrylate, divinyl benzene, a di- or tri-allyl compound including diallyl phthalate, diallyl maleate, diallyl succinate, and triallyl triazine, an allyl compound such as allyl (meth)acrylate, a conjugated diene-based compound such as 1,3-butadiene; and the like.

The acrylic rubber is to preferably have a glass transition temperature of -10°C or lower, from standpoints of flexibility, low-temperature impact resistance, and the like. The acrylic rubber having the above-mentioned glass transition temperature is typically a copolymer containing a structural unit derived from the above-mentioned crosslinkable monomer.
The content of a structural unit deriving from a crosslinkable monomer constituting the preferable acrylic rubber is preferably in the range from 0.01% to 10% by mass, more preferably from 0.05% to 8% by mass, and further preferably from 0.1% to 5% by mass, based on the total amount of structural units.
The volume average particle size of the acrylic rubber is preferably in the range from 5 to 500 nm, more preferably from 10 to 450 nm, and further preferably from 20 to 400 nm, from viewpoints of flexibility, low-temperature impact resistance and the like.
The acrylic rubber can be produced by known methods and preferable production method is an emulsion polymerization method.
Preferable as the silicone rubber is a rubber which is contained in a latex, so as to facilitate emulsion polymerization as a preferable method for the production of the rubber reinforced aromatic vinyl-based resin (I-1). Thus, this silicone rubber may be a polyorganosiloxane-based rubber manufactured by methods described, for example, in USP 2891920, USP 3294725 or the like, and the like.
The polyorganosiloxane-based rubber is preferably a silicone rubber which is contained in a latex manufactured by a method configured to shearingly mix an organosiloxane with water using a homomixer or ultrasonic mixer in the presence of a sulfonic acid-based emulsifier such as an alkylbenzenesulfonic acid and an alkylsulfonic acid, followed by condensation, for example. The alkylbenzenesulfonic acid is preferable in that the same acts as an emulsifier for the organosiloxane, and also as a polymerization initiator. At this time, combiningly using a metal alkylbenzenesulfonate, a metal alkylsulfonate, or the like, preferably exhibits an effect to stably maintain the silicone rubber upon production of the rubber reinforced aromatic vinyl-based resin (I-1). The polyorganosiloxane-based rubber may have an end capped by a hydroxyl group, alkoxy group, trimethylsilyl group, methyldiphenylsilyl group, or the like. Further, it is possible to cocondense a graft crossing agent and/or crosslinking agent as required, to the extent that the performance intended by the present invention is not deteriorated. Using them enables to improve the impact resistance.
The organosiloxane to be used for the above reaction is a compound having a structural unit represented by, for example, the following general formula (1):

$$[R^1{}_mSiO_{(4-m)/2}] \qquad (1)$$

(in the formula, $R^1$ is a substituted or unsubstituted monovalent hydrocarbon group, and m indicates an integer of 0 to 3). The compound represented by the general formula (1) has a straight, branched, or cyclic structure, and is preferably an organosiloxane having a cyclic structure. Examples of the $R^1$, i.e., the monovalent hydrocarbon group, possessed by this organosiloxane, include: an alkyl group such as methyl group, ethyl group, propyl group and butyl group; an aryl group such as phenyl group and tolyl group; an alkenyl group such as vinyl group and allyl group; a group obtained by substituting a part of hydrogen atoms bonded to a carbon atom(s) in each of these hydrocarbon groups, with a halogen atom, cyano group or the like; a group obtained by substituting at least one of hydrogen atoms in the alkyl group, with a mercapto group; and the like.
A straight or branched organosiloxane can be used as the organosiloxane in addition to the cyclic compound such as hexamethyl cyclotrisiloxane, octamethyl cyclotetrasiloxane, decamethyl cyclopentasiloxane, dodecamethyl cyclohexasiloxane, trimethyl triphenylcyclotrisiloxane, tetramethyl tetraphenylcyclotetrasiloxane, and octaphenyl cyclotetrasiloxane. These compounds may be used singly or in combination of two or more types thereof.
It is noted that the organosiloxane may be a previously condensed polyorganosiloxane having Mw of about 500 to 10,000, for example. Further, when the organosiloxane is a polyorganosiloxane, its molecular chain end may be capped by a hydroxyl group, alkoxy group, trimethylsilyl group, methyldiphenylsilyl group, or the like.
The graft crossing agent is typically a compound having a carbon-carbon unsaturated bond and an alkoxysilyl group, and an example thereof includes p-vinylphenylmethyldimethoxysilane, 2-(p-vinylphenyl)ethylmethyldimethoxysilane, 3-(p-vinylbenzoyloxy)propylmethyldimethoxysilane, and the like.
The amount of the graft crossing agent to be used is usually 10 parts or less by mass, preferably in the range from 0.2 to 10 parts by mass, and more preferably from 0.5 to 5 parts by mass, based on 100% by mass of the total amount of the organosiloxane, graft crossing agent, and crosslinking agent. If an excessively large amount of the graft crossing agent is used, the molecular weight of a resulting graft copolymer may be lower, thereby failing to obtain sufficient impact resistance. This is also apt to progress an oxidative degradation from a double bond of a polyorganosiloxane-based rubber after grafting, thereby occasionally failing to obtain a rubber reinforced aromatic vinyl-based resin having an excellent weather resistance.
Examples of the crosslinking agent include a trifunctional crosslinking agent such as methyltrimethoxysilane, ethyltrimethoxysilane, phenyltrimethoxysilane, and ethyltriethoxysilane; a tetrafunctional crosslinking agent such as tetraethoxysilane; and the like. It is possible to adopt a crosslinkable prepolymer to be obtained by previously condensation polymerization of these compounds. These crosslinking agents may be used singly or in combination of two or more types thereof.

The amount of the crosslinking agent to be used is typically 10 parts or less by mass, preferably 5 parts or less by mass, and more preferably in the range from 0.01 to 5 parts by mass, based on 100% by mass of the total amount of the organosiloxane, graft crossing agent, and crosslinking agent. If an excessively large amount of the crosslinking agent is used, the resiliency of a resulting polyorganosiloxane-based rubber may be lost, thereby deteriorating flexibility of the backsheet.

The volume average particle size of the silicone rubber is usually in the range from 5 to 500 nm, preferably form 10 to 400 nm, and further preferably from 50 to 400 nm. This volume average particle size can be readily controlled, by means of amounts of an emulsifier and water to be used upon production, a degree of dispersion upon mixing by a homomixer or ultrasonic mixer, or a charging method of the organosiloxane. If the volume average particle size is exceeding 500 nm, the appearance may be deteriorated, such as gloss deterioration.

The silicone-acryl composite rubber is a rubbery polymer containing a polyorganosiloxane-based rubber and a poly alkyl(meth)acrylic rubber. The preferable silicone-acryl composite rubber is a composite rubber having a structure where the polyorganosiloxane-based rubber and the polyalkyl(meth)acrylic rubber are mutually entwined such that they are not separable from each other.

Preferably usable as the polyorganosiloxane-based rubber is a rubber obtained by copolymerization of an organosiloxane. Examples of the organosiloxane include various reduced forms of three or more-membered rings, and preferable example thereof includes hexamethyl cyclotrisiloxane, octamethyl cyclotetrasiloxane, decamethyl cyclopentasiloxane, dodecamethyl cyclohexasiloxane, trimethyltriphenyl cyclotorisiloxane, tetramethyltetraphenyl cyclotetrasiloxane, octaphenyl cyclotetrasiloxane, and the like. These organosiloxanes may be used singly or in combination of two or more types thereof.

The content of the structural unit derived from the organosiloxane constituting the polyorganosiloxane-based rubber is preferably 50% or more by mass, and more preferably 70% or more by mass based on the total amount of structural units.

Examples of the acrylic rubber include a rubber obtained by (co)polymerization of a monomer containing a (meth)acrylic acid alkyl ester compound such as methyl acrylate, ethyl acrylate, n-propyl acrylate, n-butyl acrylate, 2-ethylhexyl acrylate, ethoxyethoxyethyl acrylate, methoxytripropyleneglycol acrylate, 4-hydroxybutyl acrylate, lauryl methacrylate, and stearyl methacrylate. These (meth)acrylic acid alkyl ester compounds may be used singly or in combination of two or more types thereof.

The monomer may contain various vinyl-based monomer including an aromatic vinyl compound such as styrene, α-methyl styrene and vinyl toluene; a cyanidated vinyl compound such as acrylonitrile and methacrylonitrile; a methacryl-modified silicone; and a fluorine-based vinyl compound in an amount of 30% or less by mass as a copolymeric component, in addition to the (meth)acrylic acid alkyl ester compound.

The acrylic rubber is preferably of a copolymer having two or more glass transition temperatures since the acrylic rubber is to be capable of providing the backsheet with a sufficient flexibility.

The silicone-acryl composite rubber may be used which is produced by the methods described, for example, in JP-A H4-239010, JP-A H4-100812, and the like.

The volume average particle size of the silicone-acryl composite rubber is preferably in the range from 5 to 500 nm, more preferably from 10 to 450 nm, and further preferably from 20 to 400 nm, from viewpoints of flexibility, low-temperature impact resistance and the like.

The ethylene α-olefin-based copolymeric rubber is a copolymer containing an ethylene unit and a structural unit formed from an α-olefin having 3 or more carbon atoms. Example thereof includes an ethylene α-olefin copolymer, an ethylene α-olefin non-conjugated diene copolymer, and the like.

Examples of the ethylene α-olefin copolymer include ethylene propylene copolymer, ethylene butene-1 copolymer, and the like. In addition, examples of the ethylene α-olefin non-conjugated diene copolymer include ethylene propylene non-conjugated diene copolymer ethylene butene-1 non-conjugated diene copolymer, and the like.

The α-olefin is preferably an α-olefin having 3 to 20 carbon atoms, and example thereof includes propylene, 1-butene, 1-pentene, 1-hexene, 4-methyl-1-pentene, 1-heptene, 1-octene, 1-decene, 1-hexadecene, 1-eicocene, and the like. In the α-olefin, preferable number of carbon atom is 3 to 12, and the more preferable is 3 to 8.

Content ratio of the ethylene unit and α-olefin unit constituting the ethylene α-olefin-based copolymeric rubber are preferably from 5% to 95% by mass and from 5% to 95% by mass, more preferably from 50% to 90% by mass and from 10% to 50% by mass, further preferably from 60% to 88% by mass and from 12% to 40% by mass, and particularly from 70% to 85% by mass and from 15% to 30% by mass, respectively. If the content of the α-olefin unit is too much, flexibility may be deteriorated.

In the case where the ethylene α-olefin-based copolymeric rubber is an ethylene α-olefin non-conjugated diene copolymer, examples of the non-conjugated diene include an alkenyl norbornene such as 5-ethylidene-2-norbornene; a cyclic diene such as dicyclopentadiene; an aliphatic diene; and the like. These compounds may be used singly or in

combination of two or more types thereof.
The content of the structural unit derived from the non-conjugated diene is preferably in the range from 1% to 30% by mass, and more preferably from 2% to 20% by mass, based on the total amounts of the structural units constituting the ethylene α-olefin non-conjugated diene copolymer. If the content of the non-conjugated diene unit is too much, the appearance and weather resistance may be deteriorated.

The content of an unsaturated group in the ethylene α-olefin-based copolymer rubber is preferably in the range from 4 to 40, in terms of an iodine value.
Further, Mooney viscosity ($ML_{1+4}$, at a temperature of 100°C; according to JIS K6300) of the ethylene α-olefin-based copolymer rubber is preferably in the range from 5 to 80, more preferably from 10 to 65, and further preferably from 15 to 45. If the Mooney viscosity is in the above range, impact resistance and flexibility are excellent.

The hydrogenated conjugated diene-based rubber is not particularly limited so long as it is a (co)polymer obtained by hydrogenating a (co)polymer containing a structural unit derived from a conjugated diene-based compound. Examples of the hydrogenated conjugated diene-based rubber include a hydrogenated product of a conjugated diene block copolymer having the following structure. Namely, the copolymer is a block copolymer in which two or more types of polymer blocks are in combination, among a polymer block A consisting of a structural unit derived from an aromatic vinyl compound, a polymer block B obtained by hydrogenating 95% or more by mol of double bond moieties of a polymer containing a structural unit derived from a conjugated diene-based compound and containing a 1,2-vinyl bond of exceeding 25% by mol, a polymer block C obtained by hydrogenating 95% or more by mol of double bond moieties of a polymer containing a structural unit derived from a conjugated diene-based compound and containing a 1,2-vinyl bond of 25% or less by mol, and a polymer block D obtained by hydrogenating 95% or more by mol of double bond moieties of a polymer consisting of a structural unit derived from an aromatic vinyl compound and a structural unit derived from a conjugated diene-based compound.

The molecular structure of the block copolymer may be branched, radial, or a combination thereof. Further, the block structure may be a diblock, triblock, multi-block, or a combination thereof.
Examples of the structure of the block copolymer include A-(B-A)n, (A-B)n, A-(B-C)n, C-(B-C)n, (B-C)n, A-(D-A)n, (A-D)n, A-(D-C)n, C-(D-C)n, (D-C)n, A-(B-C-D)n, (A-B-C-D)n, and the like [n is an integer of 1 or greater], and preferable examples are A-B-A, A-B-A-B, A-B-C, A-D-C, and C-B-C.

The aromatic vinyl compound used for the formation of the polymer blocks A and D, constituting the block copolymer is not particularly limited so long as it is a compound having at least one vinyl bond and at least one aromatic ring. Examples thereof include styrene, α-methyl styrene, methyl styrene, vinyl xylene, monochlorostyrene, dichlorostyrene, monobromostyrene, dibromostyrene, fluorostyrene, p-tert-butyl styrene, ethyl styrene, vinylnaphthalene, and the like. These compounds may be used singly or in combination of two or more types thereof. Among these, styrene is preferred.
The content of the polymer block A constituting the block copolymer is preferably in the range from 0% to 65% by mass, and more preferably from 10% to 40% by mass based on the entirety of the polymer. If the content of the polymer block A is too much, impact resistance may not be sufficient.

The polymer blocks B, C, and D are each formed by hydrogenating a block copolymer before hydrogenation obtained using a conjugated diene-based compound and an aromatic vinyl compound. Examples of the conjugated diene-based compound used for the formation of the polymer blocks B, C and D include 1,3-butadiene, isoprene, 1,3-pentadiene, chloroprene, and the like. These compounds may be used singly or in combination of two or more types thereof. Among them, 1,3-butadiene and isoprene are preferable since it is industrially utilizable and is excellent in physical properties.

Each hydrogenation rate for the polymer blocks B, C and D is 95% or more by mol and preferably 96% or more by mol.
The content of the 1,2-vinyl bond in the polymer block B is preferably exceeding 25% by mol and 90% or less by mol, and more preferably in the range from 30% to 80% by mol. If the content of the 1,2-vinyl bond is 25% or less by mol, rubbery properties may be lost and impact resistance may not be sufficient. On the other hand, if the content is exceeding 90% by mol, chemical resistance may not be sufficient.
In addition, the content of the 1,2-vinyl bond in the polymer block C is preferably 25% or less by mol, and more preferably 20% or less by mol.

The content of the 1,2-vinyl bond in the polymer block D is preferably in the range from 25% to 90% by mol, and more preferably from 30% to 80% by mol. If the 1,2-vinyl bond content is less than 25% by mol, rubbery property may be lost and impact resistance may not be sufficient. On the other hand, if the 1,2-vinyl bond content is exceeding 90% by mol, chemical resistance may not be sufficient.
Additionally, the content of the aromatic vinyl compound unit in the polymer block D is preferably 25% or less by mol, and more preferably 20% or less by mol. If the aromatic vinyl compound unit is exceeding 25% by mol, rubbery property may be lost and impact resistance may not be sufficient.

Examples of the hydrogenated conjugated diene-based monomer include a hydrogenated polybutadiene, a

hydrogenated styrene butadiene rubber, a styrene ethylenebutylene olefin crystal block polymer, an olefin crystal ethylenebutylene olefin crystal block polymer, a styrene ethylenebutylene styrene block polymer, a hydrogenated butadiene acrylonitrile copolymer, and the like.

The weight average molecular weight (Mw) of the hydrogenated conjugated diene-based rubber is preferably in the range from 10,000 to 1,000,000, more preferably from 30,000 to 800,000, and further preferably from 50,000 to 500,000. When the Mw is in the above range, excellent flexibility may be obtained.

In the following, the vinyl-based monomer (b11) for the formation of the rubber reinforced aromatic vinyl-based resin (T-1) contains an aromatic vinyl compound. That is to say, the vinyl-based monomer (b11) may be consisting of an aromatic vinyl compound, or of an aromatic vinyl compound and other monomer capable of copolymerizing with the aromatic vinyl compound. Examples of the other monomers include a cyanidated vinyl compound, a (meth)acrylic acid ester compound, a maleimide-based compound, an unsaturated acid anhydride, an unsaturated compound having a carboxyl group, an unsaturated compound having a hydroxyl group, an unsaturated compound having an epoxy group, an unsaturated compound having an oxazoline group, and the like. These monomers may be used singly or in combination of two or more thereof.

The aromatic vinyl compound is not particularly limited so long as it is a compound having at least one vinyl bond and at least one aromatic ring. An example thereof includes styrene, α-methyl styrene, o-methyl styrene, p-methyl styrene, β-methyl styrene, ethyl styrene, p-tert-butyl styrene, vinyl toluene, vinyl xylene, vinyl naphthalene, monochlorostyrene, dichlorostyrene, monobromostyrene, dibromostyrene, tribromostyrene, fluorostyrene and the like. These compounds may be used singly or in combination of two or more types thereof. In addition, styrene and α-methyl styrene are preferable among these. Particularly preferred is styrene.

Examples of the cyanidated vinyl compound include acrylonitrile, methacrylonitrile, ethacrylonitrile, α-ethyl acrylonitrile, α-isopropyl acrylonitrile, α-chloro acrylonitrile, α-fluoro acrylonitrile and the like. These compounds may be used singly or in combination of two or more types thereof. Among these, acrylonitrile is preferred.

Examples of the (meth)acrylic acid ester compound include methyl (meth)acrylate, ethyl (meth)acrylate, n-propyl (meth)acrylate, isopropyl (meth)acrylate, n-butyl (meth)acrylate, isobutyl (meth)acrylate, sec-butyl (meth)acrylate, tert-butyl (meth)acrylate, hexyl (meth)acrylate, n-octyl (meth)acrylate, 2-ethylhexyl (meth)acrylate, cyclohexyl (meth) acrylate, phenyl (meth)acrylate, benzyl (meth)acrylate and the like. These compounds may be used singly or in combination of two or more types thereof.

Examples of the maleimide-based compound include maleimide, N-methyl maleimide, N-isopropyl maleimide, N-butyl maleimide, N-dodecyl maleimide, N-phenyl maleimide, N-(2-methylphenyl)maleimide, N-(4-methylphenyl) maleimide, N-(2,6-dimethylphenyl) maleimide, N-(2,6-diethylphenyl) maleimide, N-(2-methoxyphenyl) maleimide, N-benzyl maleimide, N-(4-hydroxyphenyl)maleimide, N-naphthyl maleimide, N-cyclohexyl maleimide and the like. These compounds may be used singly or in combination of two or more types thereof. Another method for introducing a monomer unit deriving from the maleimide-based compound into the rubber reinforced aromatic vinyl-based resin (I-1) includes an imidization after copolymerization with maleic anhydride.

Examples of the unsaturated acid anhydride include maleic anhydride, itaconic anhydride, citraconic anhydride and the like. These compounds may be used singly or in combination of two or more types thereof.

Examples of the unsaturated compound having a carboxyl group include (meth)acrylic acid, ethacrylic acid, maleic acid, fumaric acid, itaconic acid, crotonic acid, cinnamic acid, and the like. These compounds may be used singly or in combination of two or more types thereof.

Examples of the unsaturated compound having a hydroxyl group include a (meth)acrylic acid ester having a hydroxyl group such as 2-hydroxymethyl (meth)acrylate, 2-hydroxyethyl (meth)acrylate, 3-hydroxypropyl (meth)acrylate, 2-hydroxybutyl (meth)acrylate, 3-hydroxybutyl (meth)acrylate, 4-hydroxybutyl (meth)acrylate, polyethylene glycol mono (meth)acrylate, polypropylene glycol mono(meth)acrylate, and a compound obtained by addition of ε-caprolacton to 2-hydroxymethyl (meth)acrylate; o-hydroxy styrene, m-hydroxy styrene, p-hydroxy styrene, o-hydroxy-α-methylstyrene, m-hydroxy-α-methylstyrene, p-hydroxy-α-methylstyrene, 2-hydroxymethyl-α-methylstyrene, 3-hydroxymethyl-α-methylstyrene, 4-hydroxymethyl-α-methylstyrene, 4-hydroxymethyl-1-vinyl naphthalene, 7-hydroxymethyl-1-vinyl naphthalene, 8-hydroxymethyl-1-vinyl naphthalene, 4-hydroxymethyl-1-isopropenyl naphthalene, 7-hydroxymethyl-1-isopropenyl naphthalene, 8-hydroxymethyl-1-isopropenyl naphthalene, p-vinylbenzyl alcohol, 3-hydroxy-1-propene, 4-hydroxy-1-butene, cis-4-hydroxy-2-butene, trans-4-hydroxy-2-butene, 3-hydroxy-2-methyl-1-propene, and the like. These compounds may be used singly or in combination of two or more types thereof.

Examples of the unsaturated compound having an epoxy group include glycidyl (meth)acrylate, 3,4-oxycyclohexyl (meth)acrylate, vinyl glycidyl ether, allyl glycidyl ether, methallyl glycidyl ether, and the like. These compounds may be used singly or in combination of two or more types thereof.

Examples of the unsaturated compound having an oxazoline group include vinyl oxazoline and the like.

In the present invention, the vinyl-based monomer (b11) preferably contains an aromatic vinyl compound and a cyanidated vinyl compound. The total amount of these monomers to be used is preferably in the range from 70% to 100% by mass and more preferably from 80% to 100% by mass based on the total of the vinyl-based monomer (b11),

from viewpoints of moldability, chemical resistance, hydrolysis resistance, dimension stability, external appearance and the like. Additionally, the ratio of the aromatic vinyl compound and cyanidated vinyl compound to be used are preferably from 5% to 95% by mass and from 5% to 95% by mass, more preferably from 50% to 95% by mass and from 5% to 50% by mass, and further preferably from 60% to 95% by mass and from 5% to 40% by mass, respectively, based on 100% by mass of the total of these monomers, from viewpoints of moldability, chemical resistance, hydrolysis resistance, dimension stability, external appearance and the like.

When the vinyl-based monomer (b11) contains a maleimide-based compound, heat resistance can be provided to the first resin layer. The preferable content of a structural unit derived from the maleimide-based compound in the aromatic vinyl-based resin will be described later.

The preferable resins as the rubber reinforced aromatic vinyl-based resin (I-1) are as follows:

(1-1) a rubber reinforced aromatic vinyl-based resin obtained by polymerizing the vinyl-based monomer (b11) consisting of an aromatic vinyl compound and a cyanidated vinyl compound in the presence of the rubbery polymer (a11);
(1-2) a rubber reinforced aromatic vinyl-based resin obtained by polymerizing the vinyl-based monomer (b11) consisting of an aromatic vinyl compound, a cyanidated vinyl compound and a maleimide-based compound in the presence of the rubbery polymer (a11); and
(1-3) a rubber reinforced aromatic vinyl-based resin obtained by polymerizing the vinyl-based monomer (b11) consisting of an aromatic vinyl compound, a cyanidated vinyl compound and a (meth)acrylic acid ester compound in the presence of the rubbery polymer (a11).

The rubber reinforced aromatic vinyl-based resin (I-1) can be produced by polymerizing the vinyl-based monomer (b11) in the presence of the rubbery polymer (a11). The preferable polymerization method may be an emulsification polymerization, suspension polymerization, solution polymerization, bulk polymerization or a method combining any of two or more polymerization methods.

When the rubber reinforced aromatic vinyl-based resin (I-1) is produced, the reaction may be conducted by charging all of the vinyl-based monomer (b11) at once in the presence of the whole amount of the rubbery polymer (a11), or by charging the vinyl-based monomer (b11) dividedly or continuously. In addition, all of the vinyl-based monomer (b11) may be added in the presence of a part of the rubbery polymer (a11) or in the absence of the rubbery polymer (a11) for polymerization. The polymerization of the vinyl-based monomer (b11) may be initiated while charging dividedly or continuously. In this case, the rest of the rubbery polymer (a11) may be charged all at once, dividedly or continuously.

In the case of producing the rubber reinforced aromatic vinyl-based resin (I-1) by emulsion polymerization, a polymerization initiator, a chain-transfer agent (molecular weight adjuster), an emulsifier, water and the like are used.

Examples of the polymerization initiator include a redox-type initiator by combining an organic peroxide such as cumene hydroperoxide, diisopropylbenzene hydroperoxide and p menthane hydroperoxide, and a reducing agent such as sugar-containing pyrophosphoric acid formulation and sulfoxylate formulation; a persulfate such as potassium persulfate; a peroxide such as benzoyl peroxide (BPO), lauroyl peroxide, tert-butylperoxy laurate and tert-butylperoxy monocarbonate; and the like. These compounds may be used singly or in combination of two or more types thereof. The polymerization initiator is usually used in an amount from 0.1% to 1.5% by mass based on the total amount of the vinyl-based monomer (b11).
The polymerization initiator can be incorporated into the reaction system all at once or continuously.

Examples of the chain-transfer agent include a mercaptan such as octyl mercaptan, n-dodecyl mercaptan, tert-dodecyl mercaptan, n-hexyl mercaptan, n-hexadecyl mercaptan, n-tetradecyl mercaptan and tert-tetradecyl mercaptan; a terpinolene, $\alpha$-methyl styrene dimer, and the like. These may be used singly or in combination of two or more types thereof. The chain-transfer agent is usually used in an amount from 0.05% to 2.0% by mass based on the total amount of the vinyl-based monomer (b11).
The chain-transfer agent can be incorporated into the reaction system all at once or continuously.

Examples of the emulsifier include an anionic surfactant and a nonionic surfactant. Examples of the anionic surfactant include a sulfuric acid ester of a higher alcohol, an alkyl benzene sulfonate including sodium dodecylbenzene sulfonate, an aliphatic sulfonate including sodium lauryl sulfonate, a higher aliphatic carboxylate, a phosphate-based compound, and the like. Examples of the nonionic surfactant include an alkyl ester type compound or alkyl ether type compound of a polyethylene glycol; and the like. These may be used singly or in combination of two or more types thereof. The emulsifier is used usually in an amount from 0.3% to 5.0% by mass based on the total amount of the vinyl-based monomer (b11).

The emulsion polymerization can be conducted in publicly known conditions according to the types of the vinyl-based monomer (b11), polymerization initiator and the like. A latex obtained by emulsion polymerization is usually subjected to solidification by a coagulant, the polymer component is pulverized, and then the product is purified by rinsing and drying. The coagulant may be used an inorganic salt such as calcium chloride, magnesium sulfate, magnesium chloride and sodium chloride; an inorganic acid such as sulfuric acid and hydrochloric acid; an organic acid such as

acetic acid and lactic acid; and the like.
In the case of making two or more rubber reinforced aromatic vinyl-based resins (I-1) contain in the aromatic vinyl-based resin, blending may be conducted after isolation of a resin from a latex. Other method is one where a mixture of latexes containing resins respectively is subjected to coagulation.

The production method for the rubber reinforced aromatic vinyl-based resin (I-1) by solution polymerization, bulk polymerization, and bulksuspension polymerization may be applied to publicly known method.

Commercially products may be used as the rubber reinforced aromatic vinyl-based resin (I-1) having an embodiment such as a butadiene rubber reinforced aromatic vinyl-based resin, an acrylic rubber reinforced aromatic vinyl-based resin, a silicone rubber reinforced aromatic vinyl-based resin, and a silicone-acryl composite rubber reinforced aromatic vinyl-based resin. For example, a rubber reinforced aromatic vinyl-based resin obtained using a silicone-acryl composite rubber as the rubbery polymer (a11) is a commercially product according to the description in JP-A H4-239010. Example thereof includes "METABLEN SX-006" (trade name) manufactured by Mitsubishi Rayon Co., Ltd., and the like.

The graft ratio of the rubber reinforced aromatic vinyl-based resin (I-1) is preferably in the range from 20% to 170%, more preferably from 30% to 170%, and particularly from 40% to 150%. If the graft ratio is too low, flexibility of the first resin layer may not be sufficient. On the other hand, if the graft ratio is too high, viscosity of the first thermoplastic resin composition may be increased, and a production of a thin-walled article may be difficult.

The graft ratio is obtainable by the following equation:

$$\text{Graft ratio } (\%) = \{(S-T)/T\} \times 100$$

In the equation, S is a mass (g) of an insoluble component obtained by: adding 1 gram of a rubber reinforced aromatic vinyl-based resin (I-1) into 20 milliliters of acetone (or acetonitrile, in case that the rubbery polymer (a11) is an acrylic rubber); shaking the mixture at a temperature of 25°C for 2 hours by a shaker; and then subjecting the mixture to centrifugal separation at a temperature of 5°C for 60 minutes with a centrifuge (rotational speed: 23,000 rpm), to separate the insoluble component from a soluble component; and T is a mass (g) of a rubbery polymer (a11) contained in 1 gram of rubber reinforced aromatic vinyl-based resin (I-1). The mass of the rubbery polymer (a11) is obtainable by: a method for calculating it from a polymerization formulation and a polymerization conversion ratio; a method for obtaining it by an infrared absorption spectrum (IR); or the like.

The rubber reinforced aromatic vinyl-based resin (I-1) may be used singly or in combination of two or more types thereof.

As mentioned above, the aromatic vinyl-based resin may be a mixture of the rubber reinforced aromatic vinyl-based resin (I-1) and the (co)polymer (I-2) obtained by polymerizing a vinyl-based monomer (b12) containing an aromatic vinyl compound. In this case, the (co)polymer (I-2) may be a homopolymer or copolymer, and be in combination of these polymers.

The vinyl-based monomer (b12) may be only an aromatic vinyl compound, or in combination of the aromatic vinyl compound and other monomer. Examples of the other monomer include a cyanidated vinyl compound, a (meth) acrylic acid ester compound, a maleimide-based compound, an unsaturated acid anhydride, an unsaturated compound having a carboxyl group, an unsaturated compound having a hydroxyl group, an unsaturated compound having an epoxy group, an unsaturated compound having an oxazoline group, and the like. These monomers may be used singly or in combination of two or more thereof. Exemplified compounds for the vinyl-based monomer (b11) may be used for these monomers.

The (co)polymer (I-2) is preferably a copolymer. In the present invention, the vinyl-based monomer (b12) is preferably of an aromatic vinyl compound and other monomers. The other monomers are preferably a cyanidated vinyl compound and a maleimide-based compound.
When the vinyl-based monomer (b12) contains an aromatic vinyl compound and cyanidated vinyl compound, the total content of these compounds is preferably in the range from 40% to 100% by mass, and more preferably from 50% to 100% by mass based on the total amount of the vinyl-based monomer (b12). The ratio of the aromatic vinyl compound and cyanidated vinyl compound to be used are preferably from 5% to 95% by mass and from 5% to 95% by mass, more preferably from 40% to 95% by mass and from 5% to 60% by mass, and further preferably from 50% to 90% by mass and from 10% to 50% by mass, respectively, based on 100% by mass of the total of these, from viewpoints of moldability, chemical resistance, hydrolysis resistance, dimension stability, external appearance, and the like.

When the (co)polymer (I-2) is a copolymer, preferable polymers are as follows:

(1-4) a copolymer consisting of a structural unit deriving from an aromatic vinyl compound (hereinafter, referred to as "structural unit (s)") and a structural unit deriving from a cyanidated vinyl compound (hereinafter, referred to as "structural unit (t)"); and

(1-5) a copolymer consisting of a structural unit (s) deriving from an aromatic vinyl compound, a structural unit (t) deriving from a cyanidated vinyl compound, and a structural unit deriving from a maleimide-based compound (hereinafter, referred to as "structural unit (u)").

When the (co)polymer (I-2) is in the embodiment (1-4) above, contents ratio of the structural unit (s) and structural unit (t) are preferably from 5% to 95% by mass and from 5% to 95% by mass, more preferably from 40% to 95% by mass and from 5% to 60% by mass, and further preferably from 50% to 90% by mass and from 10% to 50% by mass, respectively, based on 100% by mass of the total of these units, from viewpoints of moldability, chemical resistance, hydrolysis resistance, dimension stability, external appearance, and the like.
Examples of the copolymer in the embodiment (1-4) above include an acrylonitrile styrene copolymer, an acrylonitrile $\alpha$-methyl styrene copolymer, and the like.
When the (co)polymer (I-2) is in the embodiment (1-5) above, contents ratio of the structural unit (s), structural unit (t) and structural unit (u) are preferably from 20% to 90% by mass, from 5% to 50% by mass and from 1% to 40% by mass, more preferably from 25% to 85% by mass, from 10% to 45% by mass and from 5% to 35% by mass, and further preferably from 30% to 80% by mass, from 10% to 40% by mass and from 10% to 30% by mass, respectively, based on 100% by mass of the total of these units, from viewpoints of moldability, heat resistance, chemical resistance, hydrolysis resistance, dimension stability, flexibility, and the like.
Examples of the copolymer in the embodiment (1-5) above include an acrylonitrile styrene N-phenyl maleimide copolymer, and the like.
Other example as the (co)polymer (I-2) is an acrylonitrile styrene methyl methacrylate copolymer or the like.
The (co)polymer (I-2) can be produced by polymerizing the vinyl-based monomer (b12) containing an aromatic vinyl compound, in the presence or absence of a polymerization initiator. When the polymerization initiator is used, the polymerization method is preferably a solvent polymerization, bulk polymerization, emulsion polymerization, suspension polymerization and the like. These polymerizations may be combined. When the polymerization initiator is not used, thermal polymerization is usable.
The polymerization initiator to be used is one which is exemplified in the description of the production for the rubber reinforced aromatic vinyl-based resin (I-1), and the compound may be used singly or in combination of two or more types thereof. The amount of the polymerization initiator to be used is usually in the range from 0.1% to 1.5% by mass based on the total amount of the vinyl-based monomer (b12).
It is noted that a chain-transfer agent, emulsifier and the like that are exemplified in the description of the production for the rubber reinforced aromatic vinyl-based resin (I-1) may be used if necessary.
When the aromatic vinyl-based (co)polymer (I-2) is produced, the polymerization may be initiated in a state that the total amount of the vinyl-based monomer (b12) is contained in a reaction system, or the polymerization may be conducted while charging an arbitrarily selected monomer component dividedly or continuously. Further, in the case of using a polymerization initiator, batch-wise or continuous addition into the reaction system is possible.
The (co)polymer (I-2) may be used singly or in combination of two or more types thereof.
When the aromatic vinyl-based resin is a (co)polymer (I-2), the above-mentioned (co)polymer (I-2) may be used as it is.
When the aromatic vinyl-based resin is consisting of the rubber reinforced aromatic vinyl-based resin (I-1), and when the rubber reinforced aromatic resin is consisting of a mixture of the rubber reinforced aromatic vinyl-based resin (I-1) and the (co)polymer (I-2), the intrinsic viscosity [η] (measured in methyl ethyl ketone at a temperature of 30°C) of a component dissolved by acetone (acetonitrile is used in the case where an acrylic rubber is used as the rubbery polymer) in the rubber reinforced aromatic vinyl-based resin is preferably in the range from 0.1 to 2.5 dl/g, more preferably from 0.2 to 1.5 dl/g, and further preferably from 0.25 to 1.2 dl/g. The intrinsic viscosity [η] having the above range leads to an excellent moldability of the first thermoplastic resin composition and an excellent thickness accuracy of the first resin layer.
Here, the intrinsic viscosity [η] can be obtained by the following procedure.
Namely, the acetone-soluble component (or acetonitrile-soluble component, in case that the rubbery polymer is an acrylic rubber) collected after centrifugal separation upon obtaining the graft ratio in case of the aromatic vinyl-based resin (containing the rubber reinforced aromatic vinyl-based resin (I-1)), is dissolved in methyl ethyl ketone to prepare five specimens having different concentrations; and reduced viscosities of the respective concentrations are measured at a temperature of 30°C with Ubbelohde viscometer tube, thereby obtaining the intrinsic viscosity [η].
The graft ratio and intrinsic viscosity [η] can easily be controlled by varying types or amounts of the polymerization initiator, the chain-transfer agent, the emulsifier, the solvent and the like, and by varying polymerization time, polymerization temperature and other conditions in producing the rubber reinforced aromatic vinyl-based resin (I-1) and the (co) polymer (I-2).
In addition, the intrinsic viscosity [η] can easily be controlled selecting appropriately a rubber reinforced aromatic vinyl-based resin (I-1) and (co)polymer (I-2) in which intrinsic viscosities [η] are different from each other.
In the case of imparting sufficient heat resistance to the first resin layer, the aromatic vinyl-based resin preferably

contains a structural unit (u) derived from a maleimide-based compound. The structural unit (u) may be derived from the rubber reinforced aromatic vinyl-based resin (I-1) or the (co)polymer (I-2). The unit (u) may be derived from both polymers.

The content of the structural unit (u) for the formation of the first resin layer excellent in heat resistance is preferably in the range from 1% to 40% by mass, more preferably from 3% to 35% by mass, and further preferably from 5% to 30% by mass based on 100% by mass of the thermoplastic resin (I). When the content of the structural unit (u) is in the above range, a backsheet for solar cell can be obtained which is excellent in a balance between heat resistance and flexibility. In particular, when a solar cell module is produced, troubles are never caused upon handling the backsheet for solar cell. Additionally, an obverse surface side transparent protective member, an obverse surface side sealing film, solar cell elements, a reverse surface side sealing film, and a backsheet for solar cell can be press jointed without occurrence of deformations of them upon joining them, even by heating them at a temperature of 100°C or higher. If the content of the structural unit (u) contained in thermoplastic resins (I) is too much, flexibility of the first resin layer may be deteriorated.

The first resin layer is an infrared transmissible colored resin layer and preferably acts to absorb a visible light therein and transmit an infrared light therethrough. The first thermoplastic resin composition for the formation of the first resin layer is preferably a composition containing an infrared transmissible coloring agent.

The infrared transmissible coloring agent is usually in a color other than white, and is preferably a dark-colored compound colored in black, brown, dark blue, dark green, or the like. A dark-colored infrared transmissible coloring agent enables to provide a solar cell module having an excellent dark-colored external appearance without deteriorating adhesiveness between the first resin layer and an exposed surface of a filling unit which embeds solar cell elements therein.

Examples of the infrared transmissible coloring agent include a perylene-based pigment and the like. The following compounds represented by the general formulae (2) to (4) may be used as the perylene-based pigment.

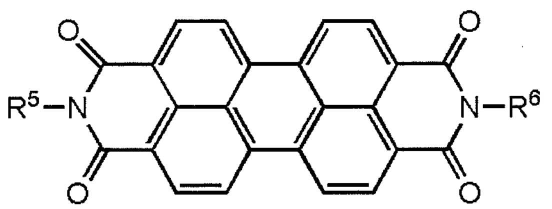

(2)

(In the formula, $R^5$ and $R^6$ may be the same or different from each other, and are butyl group, phenylethyl group, methoxyethyl group, or 4-methoxyphenylmethyl group.)

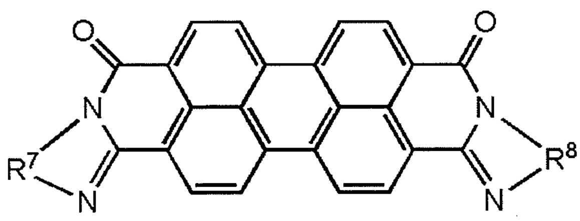

(3)

(In the formula, $R^7$ and $R^8$ may be the same or different from each other, and are phenylene group, 3-methoxyphenylene group, 4-methoxyphenylene group, 4-ethoxyphenylene group, an alkylphenylene group having 1-3 carbon atoms, hydroxyphenylene group, 4,6-dimethylphenylene group, 3,5-dimethylphenylene group, 3-chlorophenylene group, 4-chlorophenylene group, 5-chlorophenylene group, 3-bromophenylene group, 4-bromophenylene group, 5-bromophenylene group, 3-fluorophenylene group, 4-fluorophenylene group, 5-fluorophenylene group, naphhtylene group, naphthalene diyl group, pyridylene group, 2,3-pyridine diyl group, 4-methyl-2,3-pyridine diyl group, 5-methyl-2,3-pyridine diyl group, 6-methyl-2,3-pyridine diyl group, 5-methyl-3,4-pyridine diyl group, 4-methoxy-2,3-pyridine diyl group,or 4-chloro-2,3-pyridine diyl group.)

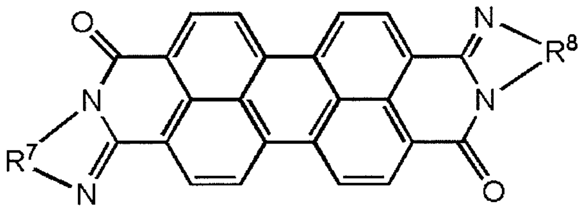

(4)

(In the formula, $R^7$ and $R^8$ may be the same or different from each other, and are phenylene group, 3-methoxyphenylene group, 4-methoxyphenylene group, 4-ethoxyphenylene group, an alkylphenylene group having 1-3 carbon atoms, hydroxyphenylene group, 4,6-dimethylphenylene group, 3,5-dimethylphenylene group, 3-chlorophenylene group, 4-chlorophenylene group, 5-chlorophenylene group, 3-bromophenylene group, 4-bromophenylene group, 5-bromophenylene group, 3-fluorophenylene group, 4-fluorophenylene group, 5-fluorophenylene group, naphhtylene group, naphthalene diyl group, pyridylene group, 2,3-pyridine diyl group, 4-methyl-2,3-pyridine diyl group, 5-methyl-2,3-pyridine diyl group, 6-methyl-2,3-pyridine diyl group, 5-methyl-3,4-pyridine diyl group, 4-methoxy-2,3-pyridine diyl group,or 4-chloro-2,3-pyridine diyl group.)

Commercially available products such as "Paliogen Black S 0084", "Paliogen Black L 0086", "Lumogen Black FK4280" and "Lumogen Black FK4281" which are all manufactured by BASF Corp. can be used as the perylene-based pigment.

The infrared transmissible coloring agent may be used singly or in combination of two or more types thereof.

The content of the infrared transmissible coloring agent in the first thermoplastic resin composition is preferably 5 parts or less by mass, and more preferably in the range from 0.1 to 5 parts by mass based on 100 parts by mass of the thermoplastic resin (I), from viewpoints of transmittivity and absorptivity of the respective light.

It is noted that other coloring agent may be used depending on the purpose or application insofar as the other coloring agent does not lower the transmittivity of an infrared light in the backsheet for solar cell of the present invention. When a yellowish pigment, bluish coloring pigment, or the like is used as the other coloring agent than the infrared transmissible coloring agent, solar cell modules having various external appearances can be established by the following combinations:

(1) Brown coloring by a combination of a black-based infrared transmissible coloring agent and a yellowish pigment; and

(2) Dark bluish coloring by a combination of a black-based infrared transmissible coloring agent and a bluish pigment.

When the other coloring agent is used, the content thereof in the first thermoplastic resin composition is usually 60 parts or less by mass, and preferably in the range from 0.01 to 55 parts by mass based on 100 parts by mass of the infrared transmissible coloring agent.

It is noted that the first thermoplastic resin composition forming the first resin layer is essentially preferably one containing no white-based coloring agents. In the case where the composition contains a white-based coloring agent, the upper limit of the content is usually 3 parts by mass and preferably 1 part by mass based on 100 parts by mass of the thermoplastic resin (I).

A coloring level of the first resin layer is not particularly limited so long as the first resin layer satisfies an infrared transmissible property. The preferable first resin layer is one which is colored to the extent that an L value at the surface of the first resin layer side for the backsheet for solar cell is preferably 40 or less, more preferably 35 or less, and further preferably 30 or less.

Carbon black is conventionally known as a dark-colored coloring agent. Since the carbon black absorbs a light having a wavelength in the infrared region, when the solar light leaks through gaps among adjacent solar cell elements toward the first resin layer containing the carbon black, the temperature of the first resin layer is increased. And the temperature of the filling unit including solar cell elements may be raised to deteriorate a power generation efficiency. In the present invention, adoption of the infrared transmissible coloring agent for the first resin layer leads to an excellent design and durability without deteriorating the power generation efficiency.

The first thermoplastic resin composition may be one containing an additive depending on the purpose or application. Examples of this additive include an antioxidant, an ultraviolet absorber, an anti-aging agent, a plasticizer, a fluorescent brightening agent, a weather resisting agent, a filler, an anti-static agent, a flame retardant, an anti-fogging agent, an anti-bacterial agent, a fungicide, an anti-fouling agent, a tackifier, a silane coupling agent, and the like. Specific compounds and amounts for these additives will be described later.

When the first thermoplastic resin composition containing an additive is prepared, a melt-kneading method is usually applied. Examples of an apparatus for melt-kneading include a single screw extruder, twin-screw extruder, Banbury mixer, kneader, continuous kneader, and the like.

The thickness of the first resin layer is usually in the range from 5 to 500 μm, and preferably from 8 to 400 μm.

The thermoplastic resin (II) contained in the second thermoplastic resin composition forming the second resin layer (white-based resin layer) is not particularly limited so long as it has thermoplastisity. Examples of the thermoplastic resin (II) constituting the second resin layer include an aromatic vinyl-based resin, a polyolefin resin, a poly vinyl chloride resin, a poly vinylidene chloride resin, a poly vinyl acetate resin, a saturated polyester resin, a polycarbonate resin, an acrylic resin, a fluorine resin, an ethylene vinyl acetate-based resin, and the like. These may be used singly or in combination of two or more types thereof as an alloy. Among these, an aromatic vinyl-based resin is preferred from the viewpoints of hydrolysis resistance and dimension stability.

The thermoplastic resin (II) may be the same as or different from the thermoplastic resin (I).

The aromatic vinyl-based resin is, as mentioned above, a rubber reinforced aromatic vinyl-based resin obtained by polymerizing a vinyl-based monomer including an aromatic vinyl compound in the presence of a rubbery polymer, a (co)polymer obtained using a vinyl-based monomer including an aromatic vinyl compound, and the like. In the present invention, the aromatic vinyl-based resin is preferably a rubber reinforced aromatic vinyl-based resin. When the thermoplastic resin (II) contains a rubber reinforced aromatic vinyl-based resin, a second resin layer having excellent hydrolysis resistance, dimension stability and impact resistance may be formed.

Examples of the aromatic vinyl-based resin include a rubber reinforced aromatic vinyl-based resin (II-1) obtained by polymerizing a vinyl-based monomer (b21) containing an aromatic vinyl compound in the presence of a rubbery polymer (a21), a (co)polymer (II-2) of a vinyl-based monomer (b22) containing an aromatic vinyl compound, and a mixture of the rubber reinforced aromatic vinyl-based resin (II-1) and the (co)polymer (II-2).

As mentioned above, the aromatic vinyl-based resin preferably contains at least one rubber reinforced aromatic vinyl-based resin (II-1). From viewpoints of impact resistance and flexibility, a combination of at least one rubber reinforced aromatic vinyl-based resin (II-1) and at least one (co)polymer (II-2) is particularly preferred. In this case, the content of the rubbery polymer (a21) in the aromatic vinyl-based resin is preferably in the range from 5% to 40% by mass, more preferably from 8% to 30% by mass, further preferably from 10% to 20% by mass, and particularly from 12% to 18% by mass, based on 100% by mass of the thermoplastic resin (II) containing the aromatic vinyl-based resin. If the content is exceeding 40% by mass, heat resistance may not be sufficient and it may be difficult to form the second resin layer using the second thermoplastic resin composition. On the other hand, if the content is less than 5% by mass, flexibility may not be sufficient.

The rubbery polymer (a21) for the formation of the rubber reinforced aromatic vinyl-based resin (II-1) may be a polymer which is exemplified as the rubbery polymer (a11) for the formation of the rubber reinforced aromatic vinyl-based resin (I-1) contained in the first thermoplastic resin composition. The rubbery polymer (a21) is preferably an acrylic rubber, an ethylene α-olefin-based rubber, a hydrogenated conjugated diene-based rubber, a silicone rubber and a silicone acryl composite rubber from the viewpoint of weather resistance. A conjugated diene-based rubber is preferable from the viewpoint of impact resistance.

The explanation for the rubbery polymer (a11) can be applied for the shape and volume average particle size of the rubbery polymer (a21).

The type, shape and volume average particle size of the rubbery polymer (a21) may be the same as or different from the rubbery polymer (a11).

The vinyl-based monomer (b21) for the formation of the rubber reinforced aromatic vinyl-based resin (II-1) may be a compound which is exemplified as the vinyl-based monomer (b11) for the formation of the rubber reinforced aromatic vinyl-based resin (I-1) contained in the first thermoplastic resin composition. The preferable vinyl-based monomer (b21) is an aromatic vinyl compound and cyanidated vinyl compound. Styrene and α-methyl styrene are preferable as the aromatic vinyl compound. Acrylonitrile is preferable as the cyanidated vinyl compound.

The vinyl-based monomer (b21) may be the same as or different from the vinyl-based monomer (b11).

Total amounts of the aromatic vinyl compound and cyanidated vinyl compound to be used in the vinyl-based monomer (b21) is preferably in the range from 70% to 100% by mass, and more preferably from 80% to 100% by mass, based on 100% by mass of the total amount of the vinyl-based monomer (b21) from viewpoints of moldability, chemical resistance, hydrolysis resistance, dimension stability, external appearance, and the like. In addition, the ratio of the aromatic vinyl compound and cyanidated vinyl compound to be used are preferably from 5% to 95% by mass and from 5% to 95% by mass, more preferably from 50% to 95% by mass and from 5% to 50% by mass, and further preferably from 60% to 90% by mass and from 10% to 40% by mass, respectively, based on 100% by mass of the total of these, from viewpoints of moldability, chemical resistance, hydrolysis resistance, dimension stability, external appearance, and the like.

When the vinyl-based monomer (b21) contains a maleimide-based compound, heat resistance can be provided to the second resin layer. The preferable content of a structural unit derived from the maleimide-based compound in the aromatic vinyl-based resin will be described later.

The preferable resins as the rubber reinforced aromatic vinyl-based resin (II-1) are as follows:

(2-1) a rubber reinforced aromatic vinyl-based resin obtained by polymerizing the vinyl-based monomer (b21) consisting of an aromatic vinyl compound and a cyanidated vinyl compound in the presence of the rubbery polymer (a21);
(2-2) a rubber reinforced aromatic vinyl-based resin obtained by polymerizing the vinyl-based monomer (b21) consisting of an aromatic vinyl compound, a cyanidated vinyl compound and a maleimide-based compound in the presence of the rubbery polymer (a21); and
(2-3) a rubber reinforced aromatic vinyl-based resin obtained by polymerizing the vinyl-based monomer (b21) consisting of an aromatic vinyl compound, a cyanidated vinyl compound and a (meth)acrylic acid ester compound in the presence of the rubbery polymer (a21).

The production method for the rubber reinforced aromatic vinyl-based resin (II-1) may be the same as one for the rubber reinforced aromatic vinyl-based resin (I-1).
The graft ratio of the rubber reinforced aromatic vinyl-based resin (II-1) is preferably in the range from 20% to 170%, more preferably from 30% to 170%, and particularly from 40% to 150%. If the graft ratio is too low, flexibility of the second resin layer may not be sufficient. On the other hand, if the graft ratio is too high, viscosity of the second thermoplastic resin composition may be increased, and a production of a thin-walled article may be difficult.
The rubber reinforced aromatic vinyl-based resin (II-1) may be used singly or in combination of two or more types thereof.
As mentioned above, the preferable aromatic vinyl-based resin is a mixture of the rubber reinforced aromatic vinyl-based resin (II-1) and a (co)polymer (II-2) obtained by polymerizing a vinyl-based monomer (b22) containing an aromatic vinyl compound. In this case, the (co)polymer (II-2) may be a homopolymer or copolymer, and be in combination of these polymers.
The vinyl-based monomer (b22) may be only an aromatic vinyl compound, or in combination of the aromatic vinyl compound and other monomer. Examples of the other monomer include a cyanidated vinyl compound, a (meth) acrylic acid ester compound, a maleimide-based compound, an unsaturated acid anhydride, an unsaturated compound having a carboxyl group, an unsaturated compound having a hydroxyl group, an unsaturated compound having an epoxy group, an unsaturated compound having an oxazoline group, and the like. These monomers may be used singly or in combination of two or more thereof. Exemplified compounds for the vinyl-based monomer (b11) may be used for these monomers.
The vinyl-based monomer (b22) may be the same as or different from the vinyl-based monomer (b12) which is used for the formation of the (co)polymer (I-2) contained in the first thermoplastic resin composition.
The (co)polymer (II-2) is preferably a copolymer. In the present invention, the vinyl-based monomer (b22) is preferably of an aromatic vinyl compound and other monomers. The other monomers are preferably a cyanidated vinyl compound and a maleimide-based compound.
When the vinyl-based monomer (b22) contains an aromatic vinyl compound and cyanidated vinyl compound, the total content of these compounds is preferably in the range from 40% to 100% by mass, and more preferably from 50% to 100% by mass based on the total amount of the vinyl-based monomer (b22). The ratio of the aromatic vinyl compound and cyanidated vinyl compound to be used are preferably from 5% to 95% by mass and from 5% to 95% by mass, more preferably from 40% to 95% by mass and from 5% to 60% by mass, and further preferably from 50% to 90% by mass and from 10% to 50% by mass, respectively, based on 100% by mass of the total of these, from viewpoints of moldability, chemical resistance, hydrolysis resistance, dimension stability, external appearance, and the like.
When the (co)polymer (II-2) is a copolymer, preferable polymers are as follows:

(2-4) a copolymer consisting of a structural unit (s) deriving from an aromatic vinyl compound and a structural unit (t) deriving from a cyanidated vinyl compound; and
(2-5) a copolymer consisting of a structural unit (s) deriving from an aromatic vinyl compound, a structural unit (t) deriving from a cyanidated vinyl compound, and a structural unit (u) deriving from a maleimide-based compound.

The production method for the (co)polymer (II-2) may be the same as one for the (co)polymer (I-2).
The (co)polymer (II-2) may be used singly or in combination of two or more types thereof.
When the aromatic vinyl-based resin is a (co)polymer (II-2), the above-mentioned (co)polymer (II-2) may be used as it is.
When the aromatic vinyl-based resin is consisting of the rubber reinforced aromatic vinyl-based resin (II-1), and when the rubber reinforced aromatic resin is consisting of a mixture of the rubber reinforced aromatic vinyl-based resin (II-1) and the (co)polymer (II-2), the intrinsic viscosity [η] (measured in methyl ethyl ketone at a temperature of 30°C) of a component dissolved by acetone (acetonitrile is used in the case where an acrylic rubber is used as the rubbery polymer) in the aromatic vinyl-based resin is preferably in the range from 0.1 to 2.5 dl/g, more preferably from 0.2 to 1.5 dl/g, and further preferably from 0.25 to 1.2 dl/g. The intrinsic viscosity [η] in the above range leads to an excellent moldability of the second thermoplastic resin composition and an excellent thickness accuracy of the second resin layer.

For the purpose of imparting sufficient heat resistance to the second resin layer, the aromatic vinyl-based resin preferably has a structural unit (u) derived from a maleimide-based compound. The structural unit (u) may be derived from the rubber reinforced aromatic vinyl-based resin (II-1) or the (co)polymer (II-2). The unit (u) may be derived from both polymers.

The content of the structural unit (u) for the formation of the second resin layer excellent in heat resistance is preferably in the range from 1% to 50% by mass, more preferably from 5% to 45% by mass, and further preferably from 10% to 40% by mass based on 100% by mass of the thermoplastic resin (II). When the content of the structural unit (u) is in the above range, a backsheet for solar cell can be obtained which is excellent in a balance between heat resistance and flexibility. In particular, when a solar cell module is produced, troubles are never caused upon handling the backsheet for solar cell. Additionally, an obverse surface side transparent protective member, an obverse surface side sealing film, solar cell elements, a reverse surface side sealing film, and a backsheet for solar cell can be press jointed without occurrence of deformations of them upon joining them, even by heating them at a temperature of 100°C or higher. If the content of the structural unit (u) contained in thermoplastic resins (II) is too much, flexibility of the first resin layer may be deteriorated.

The second resin layer is a white-based resin layer and preferably has a property to reflect a visible light and an infrared light. The second thermoplastic resin composition for the formation of the second resin layer is preferably a composition containing a white-based coloring agent.

Examples of the white-based coloring agent include titanium oxide, zinc oxide, calcium carbonate, barium sulfate, calcium sulfate, alumina, silica, $2PbCO_3 \cdot Pb(OH)_2$, [$ZnS + BaSO_4$], talc, gypsum, and the like. The white-based coloring agent may be used singly or in combination of two or more types thereof.

The content of the white-based coloring agent is preferably in the range from 1 to 45 parts by mass, more preferably from 3 to 40 parts by mass, and further preferably from 5 to 30 parts by mass based on 100 parts by mass of the thermoplastic resin (II), from a viewpoint of reflectivity at the surface of the first resin layer to a light having a wavelength of 800 to 1,400 nm when the light is irradiated to the surface of the first resin layer of the backsheet for solar cell. Excessively larger content of the white-based coloring agent occasionally leads to deterioration of flexibility of the backsheet for solar cell of the present invention.

The second resin layer (white-based resin layer) is preferably a layer having an L value (brightness) at the surface of a film consisting of the single layer of 60 or higher. More preferable L value is 65 or higher, and further preferably 70 or higher.

It is noted that the second thermoplastic resin composition may contain other coloring agent such as yellowish coloring agent and bluish coloring agent, depending on the purpose or application insofar as the coloring agent does not considerably deteriorate the reflectivity to a light having a wavelength of 800 to 1,400 nm when the light is irradiated to the surface of the first resin layer of the backsheet for solar cell. When the other coloring agent is used, the content thereof is usually 10 parts or less by mass based on 100 parts by mass of the thermoplastic resin (II).

The second thermoplastic resin composition may be one containing an additive depending on the purpose or application. Examples of this additive include an antioxidant, an ultraviolet absorber, an anti-aging agent, a plasticizer, a fluorescent brightening agent, a weather resisting agent, a filler, an anti-static agent, a flame retardant, an anti-fogging agent, an anti-bacterial agent, a fungicide, an anti-fouling agent, a tackifier, a silane coupling agent, and the like. Specific compounds and amounts for these additives will be described later.

The thickness of the second resin layer is usually in the range from 10 to 990 $\mu$m, and preferably from 20 to 500 $\mu$m.

The thermoplastic resin (III) contained in the third thermoplastic resin composition forming the third resin layer is not particularly limited so long as it has thermoplastisity. Examples of the thermoplastic resin (III) constituting the second resin layer include an aromatic vinyl-based resin, a polyolefin resin, a poly vinyl chloride resin, a poly vinylidene chloride resin, a poly vinyl acetate resin, a saturated polyester resin, a polycarbonate resin, an acrylic resin, a fluorine resin, an ethylene vinyl acetate-based resin, and the like. These may be used singly or in combination of two or more types thereof as an alloy. Among these, an aromatic vinyl-based resin is preferred from the viewpoints of hydrolysis resistance and dimension stability.

The thermoplastic resin (III) may be the same as or different from the thermoplastic resin (I). In addition, the thermoplastic resin (III) may be the same as or different from the thermoplastic resin (II).

The aromatic vinyl-based resin is, as mentioned above, a rubber reinforced aromatic vinyl-based resin obtained by polymerizing a vinyl-based monomer including an aromatic vinyl compound in the presence of a rubbery polymer, a (co)polymer obtained using a vinyl-based monomer including an aromatic vinyl compound, and the like. In the present invention, the aromatic vinyl-based resin is preferably a rubber reinforced aromatic vinyl-based resin. When the thermoplastic resin (III) contains a rubber reinforced aromatic vinyl-based resin, a second resin layer having excellent hydrolysis resistance, dimension stability and impact resistance may be formed.

Examples of the aromatic vinyl-based resin include a rubber reinforced aromatic vinyl-based resin (III-1) obtained by polymerizing a vinyl-based monomer (b31) containing an aromatic vinyl compound in the presence of a rubbery

polymer (a31), a (co)polymer (III-2) of a vinyl-based monomer (b32) containing an aromatic vinyl compound, and a mixture of the rubber reinforced aromatic vinyl-based resin (III-1) and the (co)polymer (III-2).

As mentioned above, the aromatic vinyl-based resin preferably contains at least one rubber reinforced aromatic vinyl-based resin (III-1). At least one rubber reinforced aromatic vinyl-based resin (III-1), and a combination of at least one rubber reinforced aromatic vinyl-based resin (III-1) and at least one (co)polymer (III-2) are particularly preferred. In these cases, the content of the rubbery polymer (a31) in the aromatic vinyl-based resin is preferably in the range from 5% to 40% by mass, more preferably from 8% to 30% by mass, further preferably from 10% to 20% by mass, and particularly from 12% to 18% by mass, based on 100% by mass of the thermoplastic resin (III) containing the aromatic vinyl-based resin. If the content is exceeding 40% by mass, heat resistance may not be sufficient and it may be difficult to form the third resin layer using the third thermoplastic resin composition. On the other hand, if the content is less than 5% by mass, flexibility may not be sufficient.

The rubbery polymer (a31) for the formation of the rubber reinforced aromatic vinyl-based resin (III-1) may be a polymer which is exemplified as the rubbery polymer (a11) for the formation of the rubber reinforced aromatic vinyl-based resin (I-1) contained in the first thermoplastic resin composition. The rubbery polymer (a31) is preferably an acrylic rubber, an ethylene $\alpha$-olefin-based rubber, a hydrogenated conjugated diene-based rubber, a silicone rubber and a silicone acryl composite rubber from the viewpoint of weather resistance. A conjugated diene-based rubber is preferable from the viewpoint of impact resistance.
The explanation for the rubbery polymer (a11) can be applied for the shape and volume average particle size of the rubbery polymer (a31).
The type, shape and volume average particle size of the rubbery polymer (a31) may be the same as or different from the rubbery polymer (a11). In addition, the type, shape and volume average particle size of the rubbery polymer (a31) may be the same as or different from the rubbery polymer (a21).

The vinyl-based monomer (b31) for the formation of the rubber reinforced aromatic vinyl-based resin (III-1) may be a compound which is exemplified as the vinyl-based monomer (b11) for the formation of the rubber reinforced aromatic vinyl-based resin (I-1) contained in the first thermoplastic resin composition. The preferable vinyl-based monomer (b31) is an aromatic vinyl compound and cyanidated vinyl compound. Styrene and $\alpha$-methyl styrene are preferable as the aromatic vinyl compound. Acrylonitrile is preferable as the cyanidated vinyl compound.
The vinyl-based monomer (b31) may be the same as or diferent from the vinyl-based monomer (b11) In addition, the vinyl-based monomer (b31) may be the same as or diferent from the vinyl-based monomer (b21).

Total amounts of the aromatic vinyl compound and cyanidated vinyl compound to be used in the vinyl-based monomer (b31) is preferably in the range from 70% to 100% by mass, and more preferably from 80% to 100% by mass, based on 100% by mass of the total amount of the vinyl-based monomer (b31) from viewpoints of moldability, chemical resistance, hydrolysis resistance, dimension stability, external appearance, and the like. In addition, the ratio of the aromatic vinyl compound and cyanidated vinyl compound to be used are preferably from 5% to 95% by mass and from 5% to 95% by mass, more preferably from 50% to 95% by mass and from 5% to 50% by mass, and further preferably from 60% to 90% by mass and from 10% to 40% by mass, respectively, based on 100% by mass of the total of these, from viewpoints of moldability, chemical resistance, hydrolysis resistance, dimension stability, external appearance, and the like.

When the vinyl-based monomer (b31) contains a maleimide-based compound, heat resistance can be provided to the third resin layer. The preferable content of a structural unit derived from the maleimide-based compound in the aromatic vinyl-based resin will be described later.

The preferable resins as the rubber reinforced aromatic vinyl-based resin (III-1) are as follows:

(3-1) a rubber reinforced aromatic vinyl-based resin obtained by polymerizing the vinyl-based monomer (b31) consisting of an aromatic vinyl compound and a cyanidated vinyl compound in the presence of the rubbery polymer (a31);
(3-2) a rubber reinforced aromatic vinyl-based resin obtained by polymerizing the vinyl-based monomer (b31) consisting of an aromatic vinyl compound, a cyanidated vinyl compound and a maleimide-based compound in the presence of the rubbery polymer (a31); and
(3-3) a rubber reinforced aromatic vinyl-based resin obtained by polymerizing the vinyl-based monomer (b31) consisting of an aromatic vinyl compound, a cyanidated vinyl compound and a (meth)acrylic acid ester compound in the presence of the rubbery polymer (a31).

The production method for the rubber reinforced aromatic vinyl-based resin (III-1) may be the same as one for the rubber reinforced aromatic vinyl-based resin (I-1).

The graft ratio of the rubber reinforced aromatic vinyl-based resin (III-1) is preferably in the range from 20% to 170%, more preferably from 30% to 170%, and particularly from 40% to 150%. If the graft ratio is too low, flexibility of the third resin layer may not be sufficient. On the other hand, if the graft ratio is too high, viscosity of the third thermoplastic resin composition may be increased, and a production of a thin-walled article may be difficult.

The rubber reinforced aromatic vinyl-based resin (III-1) may be used singly or in combination of two or more types thereof.

As mentioned above, the preferable aromatic vinyl-based resin is a mixture of the rubber reinforced aromatic vinyl-based resin (III-1) and a (co)polymer (III-2) obtained by polymerizing a vinyl-based monomer (b32) containing an aromatic vinyl compound. In this case, the (co)polymer (III-2) may be a homopolymer or copolymer, and be in combination of these polymers.

The vinyl-based monomer (b32) may be only an aromatic vinyl compound, or in combination of the aromatic vinyl compound and other monomer. Examples of the other monomer include a cyanidated vinyl compound, a (meth) acrylic acid ester compound, a maleimide-based compound, an unsaturated acid anhydride, an unsaturated compound having a carboxyl group, an unsaturated compound having a hydroxyl group, an unsaturated compound having an epoxy group, an unsaturated compound having an oxazoline group, and the like. These monomers may be used singly or in combination of two or more thereof. Exemplified compounds for the vinyl-based monomer (b11) may be used for these monomers.

The vinyl-based monomer (b32) may be the same as or different from the vinyl-based monomer (b12) which is used for the formation of the (co)polymer (I-2) contained in the first thermoplastic resin composition. In addition, the vinyl-based monomer (b32) may be the same as or different from the vinyl-based monomer (b22) which is used for the formation of the (co)polymer (II-2) contained in the second thermoplastic resin composition.

The (co)polymer (III-2) is preferably a copolymer. In the present invention, the vinyl-based monomer (b32) is preferably of an aromatic vinyl compound and other monomers. The other monomers are preferably a cyanidated vinyl compound and a maleimide-based compound.

When the vinyl-based monomer (b32) contains an aromatic vinyl compound and cyanidated vinyl compound, the total content of these compounds is preferably in the range from 40% to 100% by mass, and more preferably from 50% to 100% by mass based on the total amount of the vinyl-based monomer (b32). The ratio of the aromatic vinyl compound and cyanidated vinyl compound to be used are preferably from 5% to 95% by mass and from 5% to 95% by mass, more preferably from 40% to 95% by mass and from 5% to 60% by mass, and further preferably from 50% to 90% by mass and from 10% to 50% by mass, respectively, based on 100% by mass of the total of these, from viewpoints of moldability, chemical resistance, hydrolysis resistance, dimension stability, external appearance, and the like.

When the (co)polymer (III-2) is a copolymer, preferable polymers are as follows:

(3-4) a copolymer consisting of a structural unit (s) deriving from an aromatic vinyl compound and a structural unit (t) deriving from a cyanidated vinyl compound; and

(3-5) a copolymer consisting of a structural unit (s) deriving from an aromatic vinyl compound, a structural unit (t) deriving from a cyanidated vinyl compound, and a structural unit (u) deriving from a maleimide-based compound.

The production method for the (co)polymer (III-2) may be the same as one for the (co)polymer (I-2).

The (co)polymer (III-2) may be used singly or in combination of two or more types thereof.

When the aromatic vinyl-based resin is a (co)polymer (III-2), the above-mentioned (co)polymer (III-2) may be used as it is.

When the aromatic vinyl-based resin (III) is consisting of the rubber reinforced aromatic vinyl-based resin (III-1), and when the rubber reinforced aromatic resin is consisting of a mixture of the rubber reinforced aromatic vinyl-based resin (III-1) and the (co)polymer (III-2), the intrinsic viscosity [η] (measured in methyl ethyl ketone at a temperature of 30°C) of a component dissolved by acetone (acetonitrile is used in the case where an acrylic rubber is used as the rubbery polymer) in the aromatic vinyl-based resin is preferably in the range from 0.1 to 2.5 dl/g, more preferably from 0.2 to 1.5 dl/g, and further preferably from 0.25 to 1.2 dl/g. The intrinsic viscosity [η] in the above range leads to an excellent moldability of the third thermoplastic resin composition and an excellent thickness accuracy of the third resin layer.

For the purpose of imparting sufficient heat resistance to the third resin layer, the aromatic vinyl-based resin preferably has a structural unit (u) derived from a maleimide-based compound. The structural unit (u) may be derived from the rubber reinforced aromatic vinyl-based resin (III-1) or the (co)polymer (III-2). The unit (u) may be derived from both polymers.

The content of the structural unit (u) for the formation of the third resin layer excellent in heat resistance is preferably in the range from 1% to 40% by mass, more preferably from 3% to 35% by mass, and further preferably from 5% to 30% by mass based on 100% by mass of the thermoplastic resin (III). If the content of the structural unit (u) is too much, the flexibility of the third layer may be deteriorated.

In the present invention, the third resin layer may be a white-based resin layer having an L value at the surface of a film consisting of the single layer of 60 or higher. The third resin layer may be a lowly white resin layer that has an L value of not less than 1 and no more than 60, a transparent resin layer, or a resin layer which is colored to other than white. In the case where the third resin is a white-based resin layer or lowly white resin layer, a light which is passed through the first resin layer is not sufficiently reflected at the second resin layer, and when a part of the light is transmitted through

the second resin layer, the third resin layer can reflect the light. In the present invention, the third resin layer is preferably a white-based resin layer.

When the third resin layer is a white-based resin layer or a lowly white resin layer, the third thermoplastic resin composition for the formation of the third resin layer is usually a composition containing a white-based coloring agent. Examples of the white-based coloring agent include titanium oxide, zinc oxide, calcium carbonate, barium sulfate, calcium sulfate, alumina, silica, $2PbCO_3 \cdot Pb(OH)_2$, [ZnS + $BaSO_4$], talc, gypsum, and the like. The white-based coloring agent may be used singly or in combination of two or more types thereof.

When the third resin layer is a white-based resin layer, the content of the white-based coloring agent is preferably in the range from 1 to 45 parts by mass, more preferably from 3 to 40 parts by mass, and further preferably from 5 to 30 parts by mass based on 100 parts by mass of the thermoplastic resin (III), from a viewpoint of reflectivity at the surface of the first resin layer to a light having a wavelength of 800 to 1,400 nm when the light is irradiated to the surface of the first resin layer of the backsheet for solar cell. Excessively larger content of the white-based coloring agent occasionally leads to deterioration of flexibility of the backsheet for solar cell of the present invention. In the case where the content is little in the above specified range, when the third resin layer is a foamed layer or the like, a white-based resin layer can be obtained.

Additionally, when the third resin layer is a lowly white resin layer, the content of the white-based coloring agent is preferably in the range from 0.1 to 5 parts by mass, and more preferably from 0.5 to 4 parts by mass based on 100 parts by mass of the thermoplastic resin (III), from a viewpoint of reflectivity to the above-mentioned light.

It is noted that the third thermoplastic resin composition may contain other coloring agent such as yellowish coloring agent and bluish coloring agent, depending on the purpose or application insofar as the coloring agent does not considerably deteriorate the reflectivity to a light having a wavelength of 800 to 1,400 nm when the light is irradiated to the surface of the first resin layer of the backsheet for solar cell. When the other coloring agent is used, the content thereof is usually 10 parts or less by mass based on 100 parts by mass of the thermoplastic resin (III).

The third thermoplastic resin composition may be one containing an additive depending on the purpose or application. Examples of this additive include an antioxidant, an ultraviolet absorber, an anti-aging agent, a plasticizer, a fluorescent brightening agent, a weather resisting agent, a filler, an anti-static agent, a flame retardant, an anti-fogging agent, an anti-bacterial agent, a fungicide, an anti-fouling agent, a tackifier, a silane coupling agent, and the like. Specific compounds and amounts for these additives will be described later.

The thickness of the third resin layer is usually in the range from 5 to 500 $\mu$m, and preferably from 8 to 400 $\mu$m.

The first resin layer, second resin layer, and third resin layer may be continuously laminated (see Fig. 1), and an adhesive layer may be provided between the first resin layer and second resin layer, or between the second resin layer and third resin layer, for bonding resin layers (not shown). In latter case, the adhesive layer may be of a polyurethane resin composition or the like.

Next, the thermoplastic resin (IV) contained in the fourth thermoplastic resin composition for the formation of the fourth resin layer (back surface protecting layer) is not particularly limited so long as it has a thermoplasticity and example the thermoplastic resin (IV) includes a saturated polyester resin such as polyethylene terephthalate, polyethylene naphthalate and polybutylene terephthalate; a polyolefin resin such as polyethylene and polypropylene; a fluoro resin such as poly vinyl fluoride and ethylene tetrafluoroethylene copolymer; a polycarbonate resin; a polyamide resin; a poly arylate resin; a poly ether sulfone resin; a poly sulfone resin; a polyacrylonitrile; a cellulose resin such as cellulose acetate; an acrylic resin; an aromatic vinyl-based resin such as polystyrene and ABS resin; and the like. These resins may be used singly or in combination of two or more types thereof. Among these, a saturated polyester resin such as polyethylene terephthalate and a fluoro resin are preferable.

The fourth thermoplastic resin composition may be one containing an additive depending on the purpose or application. Examples of this additive include a coloring agent, an antioxidant, an ultraviolet absorber, an anti-aging agent, a plasticizer, a fluorescent brightening agent, a weather resisting agent, a filler, an anti-static agent, a flame retardant, an anti-fogging agent, an anti-bacterial agent, a fungicide, an anti-fouling agent, a tackifier, a silane coupling agent, and the like. Specific compounds and amounts for these additives will be described later.

The fourth layer may be of a single layer or a multi layer. In the latter case, the layer may be a laminate of films consisting of the same composition, or a laminate of films each consisting of different compositions. Additionally, a layer consisting of other material or other composition may be formed on the one side or both side of the film consisting of the fourth thermoplastic resin composition.

The fourth resin layer is preferably a resin layer having flame resistance. The fourth resin layer may be a layer derived from a fourth thermoplastic resin composition containing a flame retardant, a layer derived from a composition containing an aromatic ring, a hetero atom, or the like in a molecule structure, or a layer in which an organic/inorganic hybrid material is laminated on one side or both side of a film consisting of a fourth thermoplastic resin composition (irrespectively of presence or absence of a flame retardant).

The preferable flame resistance of the fourth resin layer is to exhibit a flammability in a class of VTM-2 or a class higher than it, in accordance with UL94 standards.

The fourth resin layer may be formed using a commercially available product of a resin film having flame resistance. For example, a film of "Melinex 238" (trade name) manufactured by Teijin DuPont Films Japan Ltd., "SR 55" (trade name) manufactured by SKC Co., Ltd., "Lumiler X10P", "Lumiler ZV10", "Lumiler X10S", "Lumiler S10", "Lumiler H10" and "Lumiler E20" (trade name) manufactured by Toray Ind., Inc., and the like can be used.

The thickness of the fourth resin layer is usually in the range from 10 to 500 μm, more preferably from 15 to 400 μm, and further preferably from 20 to 300 μm. If the fourth resin layer is too thin, protecting effect for the backsheet for solar cell may not be sufficient. On the other hand, if the fourth resin layer is too thick, the flexibility of the backsheet for solar cell tends to be insufficient.

The first resin layer, second resin layer, third resin layer, and fourth resin layer may be continuously laminated (see Fig. 1), or the first resin layer, second resin layer, and third resin layer may be continuously laminated and the third resin layer and fourth resin layer may be bonded via an adhesive layer (not shown). In latter case, the adhesive layer may be of a polyurethane resin composition or the like.

In the backsheet for solar cell of the present invention, a water vapor barrier layer may be further provided, as mentioned above, between the third resin layer and fourth resin layer.

The water vapor barrier layer is a layer having such a performance that its water-vapor permeability (also called "water vapor transmission rate") measured under a condition of a temperature of 40°C and a humidity of 90%RH in accordance with JIS K7129, is preferably 3 g/($m^2$·day) or less, more preferably 1 g/($m^2$·day) or less, and further preferably 0.7 g/($m^2$·day) or less.

The water vapor barrier layer is preferably a layer comprising a material having an electric insulation property.

The water vapor barrier layer may have a single-layer structure consisting of one material, or a multi-layer structure, and the water vapor barrier layer may have a single-layer structure consisting of two or more materials, or a multi-layer structure. In the present invention, it is preferable that a vapor deposited film in which a film layer consisting of a metal and/or a metal oxide is formed on the surface, is used as a water vapor barrier layer-forming material, to thereby form the water vapor barrier layer. The metal and metal oxide may each be a single substance or two or more kinds of substances.

The water vapor barrier layer-forming material may be a three-layer type film in which a layer consisting of a metal and/or metal oxide is arranged between an upper resin layer and a lower resin layer.

Examples of the metal include aluminum, and the like.

Examples of the metal oxide include an oxide of an element such as silicon, aluminum, magnesium, calcium, potassium, tin, sodium, boron, titanium, lead, zirconium and yttrium. Among them, silicon oxide, aluminum oxide, and the like are particularly preferable, from a viewpoint of water vapor barrier property.

The layer consisting of the metal and/or metal oxide may be formed by a method such as plating, vacuum deposition, ion plating, sputtering, plasma CVD and microwave CVD. It is possible to combine two or more methods with each other.

Examples of the material constituting the resin layer in the vapor deposited film include a polyester film of a polyethylene terephthalete, polyethylene naphthalate, or the like; a polyolefin film of a polyethylene, polypropylene, or the like; a poly vinylidene chloride film; a poly vinyl chloride film; a fluoro resin film; a polysulfone film; a polystyrene film; a polyamide film; a polycarbonate film; a polyacrylonitrile film; a polyimide film; and the like. The thickness of the resin layer is preferably in the range from 5 to 50 μm, and more preferably from 8 to 20 μm.

The water vapor barrier layer may be formed with a commercially available product. A film or sheet such as "TECHBARRIER AX" (trade name) manufactured by Mitsubishi Plastics Inc., "GX film" (trade name) manufactured by Toppan Printing Co., Ltd., and "ECOSYAR VE500" (trade name) manufactured by Toyobo Co., Ltd. can be used as the water vapor barrier layer forming material.

The water vapor barrier layer facing the first resin layer is not particularly limited in arrangement. In the case where a vapor deposited film is used as the water vapor barrier layer forming material, a layer consisting of a metal and/or metal oxide may be bonded to the third resin layer, or may be at outer side (reverse surface side). In addition, when the fourth resin layer is provided, the evaporated layer may be faced the fourth resin layer.

The thickness of the water vapor barrier layer is preferably in the range from 5 to 300 μm, more preferably from 8 to 250 μm, and further preferably from 10 to 200 μm. If the water vapor barrier layer is too thin, water vapor barrier property may not be sufficient. On the other hand, if the water vapor barrier layer is too thick, the flexibility of the backsheet for solar cell of the present invention may not be sufficient.

When the backsheet for solar cell of the present invention has a water vapor barrier layer, an adhesive layer can be provided between the third resin layer and/or fourth resin layer, and the water vapor barrier layer. The constituent material of the adhesive layer may be a polyurethane resin composition, an epoxy resin composition, an acrylic resin composition, and the like.

The thickness of the backsheet for solar cell of the present invention is, irrespectively of configurations of the respective layers, preferably in the range from 50 to 1,000 μm, more preferably from 60 to 800 μm, and further preferably from 80 to 600 μm.

It is possible to laminate other layer such as a decorative layer, a coated layer and a layer consisting of a recycled resin

brought about upon production, between the respective layers of the backsheet for solar cell, as desired and to the extent that the effect of the present invention is not deteriorated.

In the backsheet for solar cell of the present invention, L value (brightness) at the surface of the fourth resin layer is preferably 60 or higher, more preferably 65 or higher, and further preferably 70 or higher.

In the present invention, from standpoints of shape stability and a balance between flexibility and heat resistance of the backsheet for solar cell of the present invention, specific relationships are to be kept among a thickness ($H_A$) of the first resin layer, a thickness ($H_B$) of the second resin layer, and a thickness ($H_C$) of the third resin layer, which relationships are shown below.

$$0.4 \leqq (H_A+H_C)/H_B \leqq 2.4 \qquad (1)$$

$$0.7 \leqq H_A/H_C \leqq 1.3 \qquad (2)$$

Satisfying the equation (1) leads to an excellent balance between flexibility and heat resistance of the backsheet for solar cell of the present invention. In the case of $(H_A+H_C)/H_B<0.4$ in the present invention, flexibility is inferior. On the other hand, in the case of $(H_A+H_C)/H_B>2.4$, heat resistance is inferior. It is therefore preferable in the present invention that the equation (1) is defined as follows.

$$0.5 \leqq (H_A+H_C)/H_B \leqq 2.2$$

Satisfying the equation (2) leads to an excellent shape stability of the backsheet for solar cell of the present invention. In the case of $H_A/H_C<0.7$ in the present invention, it tends to be curled, upon heating thereof, to the fourth resin layer side (the first resin layer side is warped) . On the other hand, in the case of $H_A/H_C>1.3$, it tends to be curled, upon heating thereof, to the first resin layer side (the fourth resin layer side is warped). It is therefore preferable in the present invention that the equation (2) is defined as follows.

$$0.75 \leqq H_A/H_C \leqq 1.25$$

When thicknesses of the first resin layer, second resin layer and third resin layer are in the above-mentioned preferable ranges and relationships satisfy the equations (1) and (2) in the present invention, the shape stability of the backsheet for solar cell of the present invention is excellent, that is to say, the backsheet is allowed to be readily bent and warped at the first resin layer side, which is to be adhered to a filling unit. Therefore, the backsheet can be disposed correspondingly to the surface profile of the filling unit which embeds solar cell elements therein efficiently. When the third resin layer is omitted and the thickness of the second resin layer is increased, a balance of layer configuration is not sufficient, thereby making it difficult to obtain the excellent effect according to the present invention.

Shown below is a specific example of configuration in the backsheet for solar cell of the present invention comprising the first resin layer, second resin layer, third resin layer and fourth resin layer.

[x-1] A sheet in which the first resin layer (infrared transmissible colored resin layer), second resin layer (white-based resin layer), third resin layer, and fourth resin layer (back surface protective layer) are provided sequentially and the third resin layer is a white-based resin layer.

[x-2] A sheet in which the first resin layer (infrared transmissible colored resin layer), second resin layer (white-based resin layer), third resin layer, and fourth resin layer (back surface protective layer) are provided sequentially and the third resin layer is a lowly white resin layer.

[x-3] A sheet in which the first resin layer (infrared transmissible colored resin layer), second resin layer (white-based resin layer), third resin layer, and fourth resin layer (back surface protective layer) are provided sequentially and the third resin layer is a resin layer colored in a color other than white.

[x-4] A sheet in which the first resin layer (infrared transmissible colored resin layer), second resin layer (white-based resin layer), third resin layer, and fourth resin layer (back surface protective layer) are provided sequentially and the third resin layer is a transparent and colorless resin layer.

Further, shown below are specific examples of configuration in the backsheet for solar cell of the present invention comprising the first resin layer, second resin layer, third resin layer, water vapor barrier layer and fourth resin layer:

[y-1] A sheet in which the first resin layer (infrared transmissible colored resin layer), second resin layer (white-based resin layer), third resin layer, water vapor barrier layer and fourth resin layer (back surface protective layer) are provided sequentially and the third resin layer is a white-based resin layer.

[y-2] A sheet in which the first resin layer (infrared transmissible colored resin layer), second resin layer (white-based resin layer), third resin layer, water vapor barrier layer and fourth resin layer (back surface protective layer) are provided sequentially and the third resin layer is a lower white resin layer.

[y-3] A sheet in which the first resin layer (infrared transmissible colored resin layer), second resin layer (white-based resin layer), third resin layer, water vapor barrier layer and fourth resin layer (back surface protective layer) are provided sequentially and the third resin layer is a resin layer colored in a color other than white; and

[y-4] A sheet in which the first resin layer (infrared transmissible colored resin layer), second resin layer (white-based resin layer), third resin layer, water vapor barrier layer and fourth resin layer (back surface protective layer) are provided sequentially and the third resin layer is a colorless resin layer.

In the present invention, when a light having a wavelength of 400 to 700 nm is irradiated to a surface of the first resin layer of the backsheet for solar cell, the absorbance of the light is preferably 60% or higher, more preferably 70% or higher, and further preferably 80% or higher. Higher absorbance leads to lowered brightnesses of the backsheet for solar cell, thereby forming a dark-colored backsheet for solar cell. This leads to an improved appearance and design of a solar cell module when the same is disposed on a roof of a house or the like. It is noted that "the absorbance of the light having a wavelength of 400 to 700 nm is 60% or higher" means that an average value is 60% or higher which is calculated by once measuring absorbances of the light over the wavelength range from 400 to 700 nm at intervals of 20 nm ascendingly from 400 nm or descendingly from 700 nm, and by utilizing the thus measured absorbances, however, it does not demand that the absorbances of the light are 60% or higher throughout the wavelength range.

Additionally, when a light having a wavelength of 800 to 1,400 nm is irradiated to a surface of the first resin layer of the backsheet for solar cell, the reflectance to the light is preferably 50% or higher, more preferably 60% or higher, and further preferably 70% or higher. Higher reflectance enables to reflect at least the light having the above wavelength to the solar cell elements and improve a photoelectric conversion efficiency.

In the present invention, "the reflectance to the light having a wavelength of 800 to 1,400 nm is 50% or higher" means that an average value is 50% or higher which is calculated by once measuring reflectances to the lights at intervals of 20 nm over the wavelength range from 800 to 1,400 nm ascendingly from 800 nm or descendingly from 1,400 nm, and by utilizing the thus measured reflectances, however, it does not demand that the reflectances to the lights are 50% or higher throughout the wavelength range.

In the backsheet for solar cell of the present invention having such performance, it is preferable that 60% or more of a light having a wavelength of 400 to 700 nm is absorbed at the first resin layer, and a light having a wavelength of 800 to 1,400 nm passes through the first resin layer, and that the transmitted light having a wavelength of 800 to 1,400 nm through the first resin layer is reflected at the second resin layer at least to utilize the reflected light for photoelectric conversion.

The backsheet for solar cell of the present invention is excellent in heat resistance. A dimension change ratio of the backsheet for solar cell when the backsheet is left to stand still at a temperature of 150°C for 30 minutes is preferably ±1% or less.

In the backsheet for solar cell of the present invention, scratch resistance at the back surface side thereof, namely at the surface of the fourth resin layer is excellent.

Moreover, the backsheet for solar cell having the first resin layer, second resin layer, third resin layer, water vapor barrier layer and fourth resin layer in the present invention is excellent in water vapor barrier property at the fourth resin layer. When the water vapor transmission rate of the backsheet for solar cell is measured under a condition at a temperature of 40°C and a humidity of 90%RH according to JIS K7129, the rate is preferably 3 g/($m^2$·day) or less, and more preferably 1 g/($m^2$·day) or less. Since the backsheet for solar cell has such performance, the deterioration of solar cell elements as well as the deterioration of power generation efficiency due to invasion of water, steam or the like can be suppressed and a backsheet for solar cell excellent in durability can be obtained.

In the following, additives contained in the first thermoplastic resin composition, second thermoplastic resin composition, third thermoplastic resin composition and fourth thermoplastic resin composition are described.

Examples of the antioxidant include a hindered amine-based compound, a hydroquinone-based compound, a hindered phenol-based compound, a sulfurcontaining compound, a phosphorus-containing compound, and the like. These compounds may be used singly or in combination of two or more types thereof.

The content of the antioxidant is preferably in the range from 0.05 to 10 parts by mass with respect to 100 parts by mass of each thermoplastic resin contained in the first thermoplastic resin composition, second thermoplastic resin composition, third thermoplastic resin composition and fourth thermoplastic resin composition.

Examples of the ultraviolet absorber include a benzophenone-based compound, a benzotriazole-based compound, a triazine-based compound, and the like. These compounds may be used singly or in combination of two or more types thereof.

The content of the ultraviolet absorber is preferably in the range from 0.05 to 10 parts by mass with respect to 100 parts by mass of each thermoplastic resin contained in the first thermoplastic resin composition, second thermoplastic resin

composition, third thermoplastic resin composition and fourth thermoplastic resin composition.

Examples of the anti-aging agent include a naphtylamine-based compound, a diphenylamine-based compound, a p-phenylenediamine-based compound, a quinoline-based compound, a hydroquinone derivative-based compound, a monophenol-based compound, a bisphenol-based compound, a trisphenol-based compound, a polyphenol-based compound, a thiobisphenolbased compound, a hindered phenol-based compound, a phosphate ester-based compound, an imidazol-based compound, a dithiocarbamic acid nickel saltbased compound, a phosphate-based compound, and the like. These compounds may be used singly or in combination of two or more types thereof.

The content of the anti-aging agent is preferably in the range from 0.05 to 10 parts by mass with respect to 100 parts by mass of each thermoplastic resin contained in the first thermoplastic resin composition, second thermoplastic resin composition, third thermoplastic resin composition and fourth thermoplastic resin composition.

Examples of the plasticizer include a phthalate ester such as dimethyl phthalate, diethyl phthalate, dibutyl phthalate, diisobutyl phthalate, dioctyl phthalate, butyl octyl phthalate, di-(2-ethylhexyl) phthalate, diisooctyl phthalate and diisodecyl phthalate; a fatty acid ester such as dimethyl adipate, diisobutyl adipate, di-(2-ethylhexyl) adipate, diisooctyl adipate, diisodecyl adipate, octyldecyl adipate, di-(2-ethylhexyl) azelate, diisooctyl azelate, diisobutyl azelate, dibutyl sebacate, di-(2-ethylhexyl) sebacate and diisooctyl sebacate; a trimellitic acid ester such as isodecyl trimellitate, octyl trimellitate, n-octyl trimellitate and isononyl trimellitate; di-(2-ethylhexyl) fumarate, diethylene glycol monooleate, glyceryl monoricinoleate, trilauryl phosphate, tristearyl phosphate, tri-(2-ethylhexyl)phosphate, an epoxidized soybean oil, and the like. These compounds may be used singly or in combination of two or more types thereof.

The content of the plasticizer is preferably in the range from 0.05 to 10 parts by mass with respect to 100 parts by mass of each thermoplastic resin contained in the first thermoplastic resin composition, second thermoplastic resin composition, third thermoplastic resin composition and fourth thermoplastic resin composition.

The filler may be used which is composed of an inorganic compound or organic compound and is in a shape such as spherical (including substantially spherical and polyhedral), fibrous (straight, curved, and zigzag), planar (flat, curved), or the like.

Examples of the spherical filler include wollastonite, talc, kaolin, and the like.

Examples of the fibrous filler include an inorganic fiber such as a glass fiber and ceramic whisker, and an organic fiber such as a carbon fiber and aramid fiber.

Examples of the planar fiber include mica and the like.

The content of the plasticizer is preferably 10 or less parts by mass with respect to 100 parts by mass of each thermoplastic resin contained in the first thermoplastic resin composition, second thermoplastic resin composition, third thermoplastic resin composition and fourth thermoplastic resin composition.

Examples of the flame retardant include an organic-based flame retardant, an inorganic-based flame retardant, a reactive flame retardant and the like. These may be used singly or in combination of two or more types thereof.

Examples of the organic-based flame retardant include a halogenbased flame retardant such as a brominated epoxy-based compound, a brominated alkyltriazine compound, a brominated bisphenol-based epoxy resin, a brominated bisphenol-based phenoxy resin, a brominated bisphenol-based polycarbonate resin, a brominated polystyrene resin, a brominated crosslinked polystyrene resin, a brominated bisphenol cyanurate resin, a brominated polyphenylene ether, a decabromodiphenyl oxide, and tetrabromobisphenol A and an oligomer thereof; a phosphorus-based flame retardant including a phosphoric acid ester such as trimethyl phosphate, triethyl phosphate, tripropyl phosphate, tributyl phosphate, tripentyl phosphate, trihexyl phosphate, tricyclohexyl phosphate, triphenyl phosphate, tricresyl phosphate, trixylenyl phosphate, cresyl diphenyl phosphate, dicresyl phenyl phosphate, dimethyl ethyl phosphate, methyl dibutyl phosphate, ethyl dipropyl phosphate and hydroxyphenyl diphenyl phosphate, as well as compounds obtained by modifying these compounds with various substituents, various condensed phosphoric acid ester compounds, and a phosphazene derivative comprising elemental phosphorus and nitrogen; polytetrafluoroethylene, a guanidine salt, a silicone-based compound, a phosphazene-based compound and the like. These compounds may be used singly or in combination of two or more types thereof.

Examples of the inorganic flame retardant include aluminum hydroxide, antimony oxide, magnesium hydroxide, zinc borate, a zirconium-based compound, a molybdenum-based compound, zinc stannate and the like. These compounds may be used singly or in combination of two or more types thereof.

Examples of the reactive flame retardant include tetrabromobisphenol A, dibromophenol glycidyl ether, a brominated aromatic triazine, tribromophenol, tetrabromophthalate, tetrachlorophthalic anhydride, dibromoneopentyl glycol, poly (pentabromobenzyl polyacrylate), chlorendic acid (HET acid), chlorendic anhydride (HET anhydride), brominated phenol glycidyl ether, dibromocresyl glycidyl ether and the like. These compounds may be used singly or in combination of two or more types thereof.

The content of the flame retardant is preferably 10 or less parts by mass with respect to 100 parts by mass of each thermoplastic resin contained in the first thermoplastic resin composition, second thermoplastic resin composition, third thermoplastic resin composition and fourth thermoplastic resin composition.

When the flame retardant is formulated in the thermplastic resin composition, it is preferable that a flame retardant

auxiliary is used together. Examples of the flame retardant auxiliary include an antimony compound such as diantimony trioxide, diantimony tetraoxide, diantimony pentoxide, sodium antimonite and antimony tartrate; zinc borate, barium metaborate, alumina hydrate, zirconium oxide, ammonium polyphosphate, tin oxide, and the like. These may be used singly or in combination of two or more types thereof.

In the present invention, the production method of a backsheet for solar cell having the first resin layer, second resin layer, third resin layer and fourth resin layer is not particularly limited and is selected depending on constituent materials of the respective layers, namely respective thermoplastic resin compositions. The production methods of the backsheets for the embodiments [x-1] to [x-4] are exemplified as follows:

(1) a coextrusion method using respective thermoplastic resin compositions;
(2) a method in which four kinds of resin sheets prepared using respective thermoplastic resin composition are subjected to thermally fusion bonding or dry laminating;
(3) a method in which a laminate consisting of the first resin layer, second resin layer and third resin layer is prepared by coextrusion and then a prepared film for the fourth resin layer in advance is adhered to the laminate by thermal fusion bonding or dry lamination, or with an adhesive.

The production method of a backsheet for solar cell having the first resin layer, second resin layer, third resin layer, water vapor barrier layer and fourth resin layer is not particularly limited and is selected depending on a layer configuration, constituent materials of the respective layers, and the like. The production methods of the backsheets for the embodiments [y-1] to [y-4] are exemplified as follows:

(1) a method in which a first thermoplastic resin composition, a second thermoplastic resin composition and a third thermoplastic resin composition are subjected to coextrusion or the like to form a laminate type sheet, and then the surface of the third resin layer in the laminate type sheet and a water vapor barrier layer forming sheet (or film) are joined by thermal fusion bonding or dry lamination, or with an adhesive to form a water vapor barrier layer, subsequently a fourth thermoplastic resin composition is used to form a protective layer on the water vapor barrier layer;
(2) a method in which a first thermoplastic resin composition, a second thermoplastic resin composition and a third thermoplastic resin composition are used in the same manner as above to form a laminate type sheet, and then the surface of the third resin layer in the laminate type sheet and a water vapor barrier layer forming sheet (or film) are joined by thermal fusion bonding or dry lamination, or with an adhesive to form a water vapor barrier layer, subsequently the surface of the water vapor barrier layer and a film consisting of a fourth thermoplastic resin composition, which is prepared in advance are joined by thermal fusion bonding or dry lamination, or with an adhesive; and
(3) a method in which a film for the fourth resin layer and a water vapor barrier layer forming sheet (or film) are joined by thermal fusion bonding or dry lamination, or with an adhesive to form a water vapor barrier layer, and then the surface of the water vapor barrier layer and the surface of the third resin layer of a laminate type sheet prepared using a first thermoplastic resin composition, a second thermoplastic resin composition and a third thermoplastic resin composition are joined by thermal fusion bonding or dry lamination, or with an adhesive.

The solar cell module of the present invention is characterized by including the backsheet for solar cell of the present invention. The schematic view of the solar cell module of the present invention is shown in Fig. 3.
The solar cell module 2 of Fig. 3 may configure an obverse surface side transparent protective member 21, an obverse surface side sealing film (obverse surface side filling unit) 23, solar cell elements 25, a reverse surface side sealing film (reverse surface side filling unit) 27, and a backsheet for solar cell 1 of the present invention, disposed in this sequence from a light receiving face side (upper side in this figure) of the module for solar light. The solar cell module of the present invention may appropriately have, as necessary, various parts in addition to the constituents (not shown).

The obverse surface side transparent protective member 21 is preferably consisting of a material excellent in water vapor barrier property; and a transparent substrate containing a glass, a resin, or the like is typically used. It is noted that, since glass is excellent in transparency and weathering resistance but is insufficient in impact resistance and is heavy, it is preferable to adopt a weather resistant transparent resin in case of establishing a solar cell to be placed on a roof of a house. Examples of the transparent resin include a fluorine-based resin and the like.
The thickness of the obverse surface side transparent protective member 21 is usually in the range from about 1 to 5 mm in case of adopting glass, and is usually in the range from about 0.1 to 5 mm in case of adopting a transparent resin.

The solar cell elements 25 each have a power generating function by receiving a solar light. Usable as such solar cell elements are known ones without particular limitations, insofar as they each have a function to exhibit a photoelectromotive force. Examples thereof include a crystalline silicon solar cell element such as single crystalline silicon type solar cell element and polycrystalline silicon type solar cell element; an amorphous silicon solar cell element having single bond type or tandem structure type; a III-V group compound semiconductor solar cell element such as gallium arsenide (GaAs) and indium phosphorus (InP); a II-VI group compound semiconductor solar cell element such

as cadmium tellurium (CdTe) and copper indium selenide ($CuInSe_2$); and the like. Among these, a crystalline silicon solar cell element is preferable, and particularly preferred is a polycrystalline silicon type solar cell element. It is possible to adopt a hybrid element in which an amorphous silicon solar cell element and a thin-film polycrystalline silicon solar cell element, a thin-film microcrystalline silicon solar cell element, or a thin-film crystalline silicon solar cell element are in combination; or the like.

Although not shown in Fig. 3, the solar cell element 25 is usually provided with a wiring electrode and a take-out electrode. The wiring electrode cooperatively has a function to collect electrons generated at multiple solar cell elements by receiving a solar light, and is connected to the solar cell element in a manner to couple the solar cell element at the obverse surface side sealing film (obverse surface side filling unit) 21 side, to the solar cell element at the reverse surface side sealing film (reverse surface side filling unit) 27 side, respectively, for example. Further, the take-out electrode cooperatively has a function to take out electrons collected by the wiring electrode or the like, as an electric current.

The obverse surface side sealing film (obverse surface side filling unit) 21 and the reverse surface side sealing film (reverse surface side filling unit) 27 (hereinafter, collectively referred to as "sealing films") are typically and previously formed into sheet-like or film-like sealing films by using the same sealing film forming material or mutually different ones, and by subsequently and thermally pressure jointing solar cell elements 25 and the like thereto, between the obverse surface side transparent protective member 21 and the backsheet for solar cell 1.

The thickness of each sealing film (filling unit) is usually in the range from about 100 μm to 4 mm, preferably from about 200 μm to 3 mm, and more preferably from about 300 μm to 2 mm. Excessively smaller thicknesses occasionally lead to damages of the solar cell elements 25, while excessively larger thicknesses disadvantageously lead to increased production costs.

The sealing film forming material is usually a resin composition or a rubber composition. Examples of the resin include an olefin-based resin, an epoxy resin, a poly vinyl butyral resin, and the like. Examples of the rubber include a silicone rubber, a hydrogenated conjugated diene-based rubber, and the like. Among these, an olefin-based resin and a hydrogenated conjugated diene-based rubber are preferable.

Examples of the olefin-based resin include a polymer by polymerization of an olefin or diolefin such as ethylene, propylene, butadiene and isoprene, a copolymer of ethylene and other monomer such as vinyl acetate and an acrylic ester, an ionomer, and the like. Specific example thereof includes a polyethylene, a polypropylene, a polymethylpentene, an ethylene vinyl chloride copolymer, an ethylene vinyl acetate copolymer, an ethylene (meth)acrylic acid ester copolymer, an ethylene vinylalcohol copolymer, a chlorinated polyethylene, a chlorinated polypropylene, and the like. Among these, an ethylene vinyl acetate copolymer and an ethylene (meth)acrylic acid ester copolymer are preferable. Particularly preferred is an ethylene vinyl acetate copolymer.

Examples of the hydrogenated conjugated diene-based rubber include a hydrogenated styrene butadiene rubber, a styrene-ethylenebutylene-olefin crystal block polymer, an olefin crystal-ethylenebutylene-olefin crystal block polymer, a styrene-ethylenebutylene-styrene block polymer, and the like. The preferable is a hydrogenated product of a conjugated diene block copolymer having the following structure, i.e., a block copolymer having at least two kinds of polymer blocks selected from: a polymer block A including an aromatic vinyl compound unit; a polymer block B obtained hydrogenating 80% or more by mol of double bond moieties of a polymer containing a conjugated diene-based compound unit where the content of 1,2-vinyl bond exceeds 25%; a polymer block C obtained hydrogenating 80% or more by mol of double bond moieties of a polymer containing a conjugated diene-based compound unit where the content of 1,2-vinyl bond is 25% or less; and a polymer block D obtained hydrogenating 80% or more by mol of double bond moieties of a copolymer containing an aromatic vinyl compound unit and a conjugated diene-based compound unit.

The sealing film forming material may contain, as required, an additive including a crosslinking agent, a crosslinking aid, a silane coupling agent, a ultraviolet abosorber, an antioxidant such as a hindered phenol and a phosphite, a photostabilizer based on a hindered amine, a light diffusing agent, a flame retardant, a discoloration inhibitor, and the like. As mentioned above, the material for forming the obverse surface side sealing film (obverse surface side filling unit) 23 may be the same as or different from the material for forming the reverse surface side sealing film (reverse surface side filling unit) 27. The former is preferably the same as the latter from a viewpoint of adhesiveness.

The solar cell module of the present invention can be produced by a lamination method, for example, configured to once arrange an obverse surface side transparent protective member, an obverse surface side sealing film, solar cell elements, a reverse surface side sealing film, and a backsheet for solar cell of the present invention in this order, and to subsequently heat and pressure joint them to one another while conducting vacuuming.

The temperature in laminating method is usually in the range from about 100°C to 250°C from a viewpoint of adhesiveness of the backsheet for solar cell of the present invention. Additionally, the lamination time is usually in the range from about 3 to 30 minutes.

[Examples]

Hereinafter, the present invention will be described in detail using Examples, however, the present invention

is in no way limited by these Examples without departing from the scope of the invention. In the following, "part(s)" and "%" are based on mass unless otherwise indicated.

1. Evaluation method

Measuring methods of various evaluation items are as follows.

1-1. Rubber content in thermoplastic resin

A ratio of the total of rubber components in each thermoplastic resin for respective resin layer was calculated from a formulation upon charging of starting materials for the production of each thermoplastic resin composition constituting respective resin layer.

1-2. N-phenyl maleimide unit content in thermoplastic resin

It was calculated from a formulation upon charging of starting materials for the production of each thermoplastic resin composition constituting respective resin layer.

1-3. Glass-transition temperature (Tg)

It was measured with a differential scanning calorimeter "DSC2910" (type name) manufactured by TA Instruments in accordance with JIS K7121. When a thermoplastic resin composition contained two or more thermoplastic resins and plural Tg were obtained on a DSC curve, the even higher Tg was adopted as the applicable one.

1-4. Absorbance (%) of light having wavelength of 400 to 700 nm

A backsheet for solar cell (with a size of 50 mm X 50 mm, and a thickness listed in the applicable Table) was used as a measurement specimen to measure transmittances and reflectances with UV-VIS-NIR spectrophotometer "V-670" (type name) manufactured by JASCO Corp. Namely, the applicable light was irradiated onto a surface of the first resin layer of the measurement specimen at intervals of 20 nm over the range from 400 nm to 700 nm to measure transmittances and reflectances and calculates average values of the transmittances and reflectances. The absorbance was calculated by the following equation, based on the average value of the transmittances and the average value of the reflectances:

$$\text{Absorbance (\%)} = 100 - \{\text{transmittance (\%)} + \text{reflectance (\%)}\}.$$

1-5. Reflectances (%) to light having wavelength of 800 to 1,400 nm

The backsheet for solar cell (with a size of 50 mm X 50 mm, and a thickness listed in the applicable Table) was used as a measurement specimen, and reflectances were measured with UV-VIS-NIR spectrophotometer "V-670" (type name) manufactured by JASCO Corp. Namely, the applicable light was irradiated onto a surface of the first resin layer of the measurement specimen to measure reflectances at intervals of 20 nm over the range from 800 nm to 1,400 nm, and calculate an average value of the reflectances.

1-6. L value

L values of a surface of the first resin layer side and a surface of the fourth resin layer side of the backsheet for solar cell (with a size of 50 mm X 50 mm, and a thickness listed in the applicable Table) were measured with a spectrophotometer "TCS-II" (type name) manufactured by Toyo Seiki Seisaku-Sho, Ltd.

1-7. Heat resistance

The backsheet for solar cell having a thickness listed in the applicable Table was subjected to cutting to prepare a test piece with a size of 120 mm (MD; resin extruding direction) X 120 mm (TD; direction orthogonal to MD). Subsequently, centrally drawn on the test piece was a square reference line of 100 mm (MD) X 100 mm (TD), and the test piece was left to stand still in a constant temperature bath at a temperature of 150°C for 30 minutes. Thereafter, the test

piece was cooled, and the length of the reference line was measured, to calculate a dimension change ratio:

$$\text{Dimension change ratio (\%)} = [\{(\text{length of reference line before heating}) - (\text{length of reference line after heating})\} / (\text{length of reference line before heating})] \times 100.$$

Further, the shape of the test piece after the procedure was visually observed, and judged based on the following criteria:

1; deformation was not observed,
2; only slight deformation was observed, and
3; deformation was observed.

1-8. Flexibility

The backsheet for solar cell having a thickness listed in the applicable Table was subjected to cutting to prepare a test piece with a size of 100 mm (MD) X 100 mm (TD). Subsequently, the test piece was folded along a symmetric axis in the MD direction, followed by further folding along another symmetric axis in the TD direction. The thus folded test piece was subjected to two times a reciprocative movement of an adopted manual pressurizing roll (2,000g) at a speed of 5 mm/sec, on the fold lines according to JIS Z0237. Thereafter, the test piece was unfolded along the fold lines into an original state, and visually observed to judge it based on the following criterion. That test piece was to be excellent in flexibility, which was not cracked along the fold lines.

1: The test piece was not cracked along fold lines, and not cracked along the fold lines even after folded and unfolded again;
2: Although the test piece was not cracked along fold lines, it was cracked along the fold lines after folded and unfolded again; and
3: The test piece was cracked along fold lines.

1-9. Hydrolysis resistance (retention of rupture stress)

The backsheet for solar cell having a thickness listed in the applicable Table was subjected to cutting to prepare a test piece with a size of 200 mm (MD) X 200 mm (TD). Subsequently,the test piece was left to stand still for 300 hours under a condition of a temperature of 105°C and a humidity of 100%RH, followed by cutting into strips each in 200 mm length by 15 mm width to measure a rupture stress according to JIS K7127 with universal testing system "Autograph AG2000" (type name) manufactured by Shimadzu Corp. The distance between chucks upon setting a sample for measurement was 100 mm, and a pulling speed was 300 mm/min. A retention rate of rupture stress was calculated according to the following equation from the obtained measured values:

$$\text{Retention rate of rupture stress (\%)} = \{\text{rupture stress (N/15mm) after treatment at temperature of 105°C, humidity of 100\%RH for 300 hours}) / (\text{initial rupture stress (N/15mm) (before treatment)}\} \times 100.$$

1: retention rate exceeded 80%;
2: retention rate was 50% to 80%; and
3: retention rate was less than 50%.

1-10. Hydrolysis resistance (measurement of deformation state)

Each test piece after the high-temperature and high-humidity treatment in the item 1-9, was visually observed, and judged based on the following criteria:

1; deformation was not observed,
2; deformation was slightly observed, and
3; deformation was observed.

1-11. Improvement rate of photoelectric conversion efficiency

In a chamber conditioned to a temperature of 25°C±2°C and a humidity of 50±5%RH, Solar Simulator "PEC-11" (type name) manufactured by Peccell Technologies Inc. was used to produce a solar cell module. A glass having a thickness of 3 mm and a backsheet for solar cell were arranged on an obverse surface and a reverse surface, respectively, of a 1/4 polycrystalline silicon cell in which the photoelectric conversion efficiency of the cell itself having been measured in advance, in a manner to interpose the silicon cell between the glass and the backsheet for solar cell, and an EVA was then introduced into between the glass and the backsheet for solar cell to seal the silicon cell, thereby fabricating a solar cell module. Then, light was irradiated thereto, and a photoelectric conversion efficiency was measured immediately thereafter so as to decrease an influence of temperature. Thus obtained photoelectric conversion efficiency and photoelectric conversion efficiency of the cell itself were used to obtain an improvement rate of photoelectric conversion efficiency:

Improvement rate of photoelectric conversion efficiency (%) = {(photoelectric conversion efficiency of module - photoelectric conversion efficiency of cell itself) / (photoelectric conversion efficiency of cell itself)} X 100.

1-12. Heat storage property

The backsheet for solar cell (with a size of 50 mm X 50 mm, and a thickness listed in the applicable Table) was used as a measurement specimen, and the measurement specimen was irradiated, at a surface of its first resin layer side, by an infrared lamp (power of 100 W) from a height of 200 mm, in a chamber conditioned to a temperature of 25°C±2°C and a humidity of 50±5%RH. The temperature of the surface after irradiation for 60 minutes was measured by a surface thermometer. The unit is °C.

1-13. Weather resistance

The backsheet for solar cell having a thickness listed in the applicable Table was subjected to cutting to prepare a test piece with a size of 500 mm (MD) X 30 mm (TD). Subsequently, the test piece was subjected, at a surface of its first resin layer side, to an exposure test by repeating the following steps 1 to 4, to thereby calculate a color tone change value ΔE between a color tone before exposure and a color tone after exposure for 100 hours. The apparatus was "Metaling Vertical Weather Meter MV3000" (type name) manufactured by Suga Test Instruments Co., Ltd.

Step 1: irradiation, 0.53 kW/$m^2$, 63°C, 50%RH, 4 hours;
Step 2: irradiation + rainfall, 0.53 kW/$m^2$, 63°C, 95%RH, 1 minute;
Step 3: fully dark, 0 kW/$m^2$, 30°C, 98%RH, 4 hours; and
Step 4: irradiation + rainfall, 0.53 kW/$m^2$, 63°C, 95%RH, 1 minute.

ΔE was calculated based on the following equation, from Lab (L: brightness, a: redness, b: yellowness) data obtained by spectrophotometer "V-670" (type name) manufactured by JASCO Corp.

$$\Delta E = \sqrt{\{(L_1-L_0)^2 + (a_1-a_0)^2 + (b_1-b_0)^2\}}$$

(in the equation, $L_1$, $a_1$, and $b_1$ are values after exposure, and $L_0$, $a_0$, and $b_0$ are values before exposure.)
Smaller value of ΔE indicates smaller change of color and thus more excellent weather resistance. The weather resistance was judged based on the following criteria:

1; ΔE was 10 or less, and
2; ΔE exceeded 10.

1-14. Flame resistance

The backsheet for solar cell (with a size of 20 mm X 100 mm, and a thickness listed in the applicable Table)

was used as a test piece. The test piece was suspended longitudinally and vertically, and the lower end of the test piece was contacted with a flame by adopting a burner for V tests according to UL94 for 5 seconds, in a state that the top end of the burner was separated from the lower end of the test piece by 10 mm. After completion of flame contact, the combusted state of the flame-contacted portion of the test piece was visually observed, and judged based on the following criteria:

1; not combusted, and
2; combusted.

1-15. Scratch resistance

A surface of the fourth layer side of the backsheet for solar cell was subjected to 500 times of a reciprocative friction by a cotton canvas cannequin No. 3, under a vertical load of 500 g using a dynamic rubbing tester manufactured by Tosoku Seimitsu Kogyo Ltd. The surface thereafter was observed by a visual inspection, and judged based on the following criteria:

3; no scratches were observed,
2; a slight scratch was observed, and
1; scratches were clearly observed.

1-16. Water vapor barrier property

The water vapor transmission rate was measured with a water vapor permeability-measuring apparatus "PERMATRAN W3/31" (type name) manufactured by MOCON Inc. under conditions of a temperature of 40°C and a humidity of 90%RH in accordance with JIS K7129B. A surface of the fourth resin layer of the backsheet for solar cell was arranged as a transmission surface at a water vapor side.

2. Starting materials for production of backsheet for solar cell 2-1. Silicone-acryl composite rubber reinforced styrene-based resin (rubber reinforced resin A1)

Commercially product (trade name "METABLEN SX-006" manufactured by Mitsubishi Rayon Co., Ltd.) was used. This is a resin obtained by grafting an acrylonitrile styrene copolymer to a silicone-acryl composite rubber, and has a content of the silicone-acryl composite rubber of 50%, a graft ratio of 80%, an intrinsic viscosity [η] (measured in methyl ethyl ketone at a temperature of 30°C) of 0.38 dl/g, and a glass transition temperature (Tg) of 135°C.

2-2. Silicone rubber reinforced styrene-based resin (rubber reinforced resin A2)

1.3 part of p-vinylphenylmethyldimethoxysilane and 98.7 parts of octamethylcyclotetrasiloxane were mixed, and this mixture was charged into 300 parts of distilled water containing 2.0 parts of dodecyl benzenesulfonic acid dissolved therein. A homogenizer was used for stirring for three minutes to emulsify and disperse. The emulsified dispersion was transferred into a separable flask provided with a condenser, a nitrogen inlet, and a stirrer, followed by heating at 90°C for six hours while stirring. Subsequently, the dispersion was held at 5°C for 24 hours to complete the condensation and obtain a latex containing a polyorganosiloxane-based rubber. The condensation ratio was 93%. Thereafter, this latex was neutralized to pH7, with an aqueous solution of sodium carbonate. The resulting polyorganosiloxane-based rubber has a volume average particle size of 300 nm.
Next, a batch polymerization component consisting of 100 parts of ion exchange water, 1.5 part of potassium oleate, 0.01 part of potassium hydroxide, 0.1 part of tert-dodecyl mercaptan, a latex adjusted to pH7 which contains 40 parts of the above-mentioned polyorganosiloxane-based rubber, 15 parts of styrene, and 5 parts of acrylonitrile were charged into a glass-made flask of an inner volume of 7 liters and provided with a stirrer. Stirring was conducted while increasing temperature. 0.1 part of diisopropylbenzene hydroperoxide and an aqueous solution of an activator consisting of 0.1 part of ethylenediamine tetraacetic acid sodium, 0.003 part of ferrous sulfate, 0.2 part of sodium formaldehyde sulfoxylate dihydrate, and 15 parts of ion exchange water were added into the batch polymerization component at a time where the temperature reached 45°C, to conduct polymerization for one hour.
After that, an incremental polymerization component consisting of 50 parts of ion exchange water, 1 part of potassium oleate, 0.02 part of potassium hydroxide, 0.1 part of tert-dodecyl mercaptan, 0.2 part of diisopropylbenzene hydroperoxide, 30 parts of styrene and 10 parts of acrylonitrile were continuously added into the reaction system over three hours to continue the polymerization. After completion of the addition, stirring was continued. After one hour, 0.2 part of 2,2'-methylene-bis(4-ethyl-6-tert-butylphenol) was added into the reaction system to terminate the polymerization and obtain

a latex containing a silicone rubber reinforced styrene-based resin (rubber reinforced resin A2). Subsequently, 1.5 part of sulfuric acid was added into the latex to solidify a resin component at a temperature of 90°C, followed by conduction of water washing, dewatering, and drying of the resin component, thereby obtaining the silicone rubber reinforced styrene-based resin (rubber reinforced resin A2). The resin had a glass transition temperature (Tg) of 108°C, a content of the polyorganosiloxane-based rubber of 40%, a graft ratio of 84%, and an intrinsic viscosity [η] (measured in methyl ethyl ketone at a temperature of 30°C) of 0.60 dl/g.

2-3. Acrylic rubber reinforced aromatic vinyl-based resin (Rubber reinforced resin A3)

50 parts (calculated as solid content) of latex having a solid content concentration of 40% containing an acrylic rubbery polymer (volume average particle size: 100 nm, gel content: 90%) obtained by emulsion polymerization of 99 parts of n-butyl acrylate and 1 part of allyl methacrylate was charged into a reaction vessel, and the latex was diluted by introducing thereinto 1 part of sodium dodecylbenzene sulfonate and 150 parts of ion exchange water. After that, the interior of the reaction vessel was purged with a nitrogen gas; 0.02 part of ethylenediamine tetraacetic acid disodium, 0.005 part of ferrous sulfate, and 0.3 part of sodium formaldehyde sulfoxylate were added and the mixture was heated to 60°C while stirring.
In turn, 50 parts of a mixture of 37.5 parts of styrene and 12.5 parts of acrylonitrile; 1.0 part of terpinolene; and 0.2 part of cumene hydroperoxide were charged into a container and the interior of the container was purged with a nitrogen gas to prepare a monomer composition.
Subsequently, the monomer composition was added into the reaction vessel at a constant flow rate over 5 hours in a manner to conduct polymerization at a temperature of 70°C, thereby obtaining a latex. Added into this latex was magnesium sulfate, to solidify the resin component. Thereafter, the solidified component was washed with water and dried, thereby obtaining an acrylic rubber reinforced aromatic vinyl-based resin (rubber reinforced resin A3). The content of the acrylic rubbery polymer was 50%, a graft ratio was 93%, an intrinsic viscosity [η] was 0.30 dl/g (at 30°C, in methyl ethyl ketone), and a glass transition temperature (Tg) was 108°C.

2-4. Butadiene rubber reinforced aromatic vinyl-based resin (rubber reinforced resin A4)

75 parts of ion exchange water, 0.5 part of potassium rosinate, 0.1 part of tert-dodecyl mercaptan, 32 parts (calculated as solid content) of a polybutadiene latex (volume average particle size: 270 nm, gel content: 90%), 8 parts (calculated as solid content) of styrene butadiene copolymer latex (styrene unit content: 25%; volume average particle size: 550 nm; gel content of 50%), 15 parts of styrene, and 5 parts of acrylonitrile were charged into a glass-made reaction vessel having a stirrer and the mixture was heated in a nitrogen gas stream, while stirring. When the interior temperature reached 45°C, added into the mixture was an aqueous solution prepared by dissolving 0.2 part of sodium pyrophosphorate, 0.01 part of ferrous sulfate 7-hydrate, and 0.2 part of glucose, into 20 parts of ion exchange water. After that, 0.07 part of cumene hydroperoxide was added into the mixture to initiate polymerization at a temperature of 70°C, followed by polymerization for one hour.
Then, 50 parts of ion exchange water, 0.7 part of potassium rosinate, 30 parts of styrene, 10 parts of acrylonitrile, 0.05 part of tert-dodecyl mercaptane, and 0.01 part of cumene hydroperoxide were continuously added into the system, over 3 hours, to continue the polymerization. After polymerization for one hour, added into the mixture was 0.2 part of 2,2'-methylene-bis(4-ethylene-6-tert-butylphenol) to terminate the polymerization, thereby obtaining a latex.
Subsequently, magnesium sulfate was added into this latex, to solidify the resin component. Thereafter, the solidified component was washed with water and dried, thereby obtaining a butadiene rubber reinforced aromatic vinyl-based resin (rubber reinforced resin A4). The content of the butadiene rubber was 40%, a graft ratio was 72%, an intrinsic viscosity [η] of an acetone soluble component was 0.47 dl/g, and a glass transition temperature (Tg) was 108°C.

2-5. Acrylonitrile styrene copolymer

AS resin "SAN-H" (trade name) manufactured by Techno Polymer Co., Ltd. was used. Its glass-transition temperature (Tg) is 108°C.

2-6. Acrylonitrile styrene N-phenyl maleimide copolymer

Acrylonitrile styrene N-phenyl maleimide copolymer "POLYIMILEX PAS1460" (trade name) manufactured by NIPPON SHOKUBAI CO., LTD. was used. The polymer has an N-phenyl maleimide unit in an amount of 40% and a styrene unit amount of 51%, and has an Mw of 120,000 determined relative to polystyrene standards by GPC. Its glass-transition temperature (Tg) is 173°C.

2-7. White-based coloring agent

Titanium oxide "Tipaque CR-50-2" (trade name) manufactured by ISHIHARA SANGYO KAISHA, LTD. was used. Its averaged primary particle diameter is 0.25 μm.

2-8. Infrared transmissible coloring agent

Perylene-based black pigment "Lumogen BLACK FK4280" (trade name) manufactured by BASF Corp. was used.

2-9. Yellow coloring agent

Quinophthalone-based yellow pigment "Paliotol Yellow K0961HD" (trade name) manufactured by BASF Corp. was used.

2-10. Carbon black

"Carbon black #45" (trade name) manufactured by Mitsubishi Chemical Corp. was used.

2-11. Fourth Resin layer (back surface protective layer) forming film (IV-1)

A PET film "Melinex 238" (trade name) manufactured by Teijin DuPont Films Japan Ltd. was used. The thickness is 75 μm.

2-12. Fourth Resin layer (back surface protective layer) forming film (IV-2)

A PET film "SR55" (trade name) manufactured by SKC Co., Ltd. was used. The thickness is 75 μm.

2-13. Fourth Resin layer (back surface protective layer) forming film (IV-3)

A PET film "Lumiler X10P" (trade name) manufactured by Toray Ind., Inc. was used. The thickness is 50 μm.

2-14. Water vapor barrier layer forming film (R-1)

Transparent vapor deposited film "TECHBARRIER AX" (trade name) manufactured by Mitsubishi Plastics Inc. was used. It is a transparent film having a silica vapor deposited on one side of a PET film. The thickness is 12 μm, and a water vapor transmission rate (JIS K7129) is 0.15 g/($m^2$·day).

2-15. Water vapor barrier layer forming film (R-2)

Two components vapor deposited barrier film "ECOSYAR VE500" (trade name) manufactured by TOYOBO Co., Ltd. was used. It is a transparent film having a vapor (silica/alumina) deposited on one side of a PET film. The thickness is 12 μm, and a water vapor transmission rate is 0.5 g/($m^2$·day).

3. Preparation of first thermoplastic resin composition

Production Example 1-1

A thermoplastic resin and a coloring agent were mixed at a ratio shown in Table 1 using Henschel Mixer. Thereafter, the compositions were each melted and kneaded with a twin-screw extruder "TEX44" (type name) manufactured by The Japan Steel Works, LTD. at a barrel temperature of 270°C, thereby obtaining a first thermoplastic resin composition (I-1) in a form of pellet (see Table 1).

Production Examples 1-2 to 1-7

First thermoplastic resin compositions (I-2) to (I-7) in a form of pellet were obtained in the same manner as those in Production Example 1-1 except that thermoplastic resins and coloring agents were used at ratios shown in Table 1 (see Table 1).

Table 1

| | | First thermoplastic resin composition | | | | | | |
|---|---|---|---|---|---|---|---|---|
| | | I-1 | I-2 | I-3 | I-4 | I-5 | I-6 | I-7 |
| Charging amount | Thermoplastic resin (parts) | | | | | | | |
| | Rubber reinforced resin A1 | 30 | 30 | | | | | 30 |
| | Rubber reinforced resin A2 | | | 40 | | 20 | | |
| | Rubber reinforced resin A3 | | | | 30 | 15 | | |
| | Rubber reinforced resin A4 | | | | | | 40 | |
| | Acrylonitrile styrene copolymer | 30 | 30 | 20 | 30 | 25 | 20 | 30 |
| | Acrylonitrile styrene N-phenyl maleimide copolymer | 40 | 40 | 40 | 40 | 40 | 40 | 40 |
| | Coloring agent (parts) | | | | | | | |
| | Infrared transmissible coloring agent | 2 | 1 | 4 | 1 | 1 | 1 | |
| | Yellow coloring agent | 1 | 0.5 | 2 | 0.5 | 0.5 | 0.5 | |
| | Carbon black | | | | | | | 5 |
| Content | Rubber content *1 (%) | 15 | 15 | 16 | 15 | 15.5 | 16 | 15 |
| | N-phenyl maleimide unit content *1 (%) | 16 | 16 | 16 | 16 | 16 | 16 | 16 |
| Glass transition temperature of resin (°C) | | 135 | 135 | 135 | 135 | 135 | 135 | 135 |

*1 It is a content based on 100% of a thermoplastic resin.

4. Preparation of second thermoplastic resin composition Production Example 2-1

A thermoplastic resin and a coloring agent were mixed at a ratio shown in Table 2 using Henschel Mixer. Thereafter, the compositions were each melted and kneaded with a twin-screw extruder "TEX44" (type name) manufactured by The Japan Steel Works, LTD. at a barrel temperature of 270°C, thereby obtaining a second thermoplastic resin composition (II-1) in a form of pellet (see Table 2).

Production Examples 2-2 to 2-8

Second thermoplastic resin compositions (II-2) to (II-8) in a form of pellet were obtained in the same manner as those in Production Example 2-1 except that thermoplastic resins and coloring agents were used at ratios shown in Table 2 (see Table 2). The second thermoplastic resin composition (II-7) is a composition which does not contain titanium

oxide and does not lead to a white-based resin layer.

Table 2

| | | | Second thermoplastic resin composition | | | | | | | |
|---|---|---|---|---|---|---|---|---|---|---|
| | | | II-1 | II-2 | II-3 | II-4 | II-5 | II-6 | II-7 | II-8 |
| Charging amount | Thermoplastic resin | (parts) | | | | | | | | |
| | | Rubber reinforced resin A1 | 30 | 30 | | | | | 30 | 30 |
| | | Rubber reinforced resin A2 | | | 35 | | 20 | | | |
| | | Rubber reinforced resin A3 | | | | 30 | 15 | | | |
| | | Rubber reinforced resin A4 | | | | | | 35 | | |
| | | Acrylonitrile styrene copolymer | 8 | 8 | 3 | 8 | 3 | 3 | 8 | 70 |
| | | Acrylonitrile styrene N-phenyl maleimide copolymer | 62 | 62 | 62 | 62 | 62 | 62 | 62 | |
| | Coloring agent | (parts) | | | | | | | | |
| | | Titanium oxide | 20 | 10 | 20 | 15 | 15 | 15 | 0 | 20 |
| Content | Rubber content | *1 (%) | 15 | 15 | 14 | 15 | 15.5 | 14 | 15 | 15 |
| | N-phenyl maleimide unit content | *1 (%) | 24.8 | 24.8 | 24.8 | 24.8 | 24.8 | 24.8 | 24.8 | 0 |
| Glass transition temperature of resin (°C) | | | 155 | 155 | 155 | 155 | 155 | 155 | 155 | 108 |

*1 It is a content based on 100% of a thermoplastic resin.

5. Preparation of third thermoplastic resin composition Production Example 3-1

A thermoplastic resin and a coloring agent were mixed at a ratio shown in Table 3 using Henschel Mixer. Thereafter, the compositions were each melted and kneaded with a twin-screw extruder "TEX44" (type name) manufactured by The Japan Steel Works, LTD. at a barrel temperature of 270°C, thereby obtaining a third thermoplastic resin composition (III-1) in a form of pellet (see Table 3).

Production Examples 3-2 to 3-6

Third thermoplastic resin compositions (III-2) to (III-6) in a form of pellet were obtained in the same manner as those in Production Example 3-1 except that thermoplastic resins and coloring agents were used at ratios shown in Table 3 (see Table 3).

Table 3

| | | Third thermoplastic resin composition | | | | | |
|---|---|---|---|---|---|---|---|
| | | III-1 | III-2 | III-3 | III-4 | III-5 | III-6 |
| Charging amount | Thermoplastic resin (parts) | | | | | | |
| | Rubber reinforced resin A1 | 30 | | | | | 30 |
| | Rubber reinforced resin A2 | | 40 | | 20 | | |
| | Rubber reinforced resin A3 | | | 30 | 15 | | |
| | Rubber reinforced resin A4 | | | | | 40 | |
| | Acrylonitrile styrene copolymer | 30 | 20 | 30 | 25 | 20 | 30 |
| | Acrylonitrile styrene N-phenyl maleimide copolymer | 40 | 40 | 40 | 40 | 40 | 40 |
| | Coloring agent (parts) | | | | | | |
| | Titanium oxide | 20 | 20 | 20 | 15 | 15 | 0 |
| Content | Rubber content *1 (%) | 15 | 16 | 15 | 15.5 | 16 | 15 |
| | N-phenyl maleimide unit content *1 (%) | 16 | 16 | 16 | 16 | 16 | 16 |
| Glass transition temperature of resin (°C) | | 135 | 135 | 135 | 135 | 135 | 135 |

*1 It is a content based on 100% of a thermoplastic resin.

6. Production and evaluation of backsheet for solar cell (1)

Example 1-1

A multi-layer type film forming machine provided with three extruders each comprising a T-die having a die width of 1,400 mm and a lip distance of 1.5 mm, and a screw of 65 mm diameter was used, and the first thermoplastic resin composition (I-1), second thermoplastic resin composition (II-1) and third thermoplastic resin composition (III-1)

were supplied to the extruders. Then, the molten resins were discharged from the T-dies at a temperature of 270°C, respectively, to form a three-layer type soft film. After that, this three-layer type soft film was cooled and solidified while being surface-contacted, by air knife, to a cast roll having a surface temperature controlled to be 95°C, to form a laminated film having a thickness of 75 μm. The thickness of the first resin layer, second resin layer and third resin layer were shown in Table 4. The thickness of the film was measured with a thickness gauge "ID-C1112C" (type name) manufactured by Mitutoyo Corp. and was an average value of those measured values which was obtained by once cutting a film piece out of the produced film after a lapse of one hour from commencement of production thereof, and by measuring thicknesses of the film piece at its widthwise center and at points (n=107) at intervals of 10 mm from the widthwise center toward both edges. The values at measured points within a range of 20 mm from each edge of the film piece were excluded from the calculation of the average value.
Subsequently, a fourth resin layer (back surface protective layer) forming film (IV-1) was adhered with a polyurethane-based adhesive onto an outer surface of the third resin layer of the laminated film to obtain a backsheet for solar cell. Various evaluations were conducted for the backsheet for solar cell. The results are shown in Table 4.

Examples 1-2 to 1-10 and Comparative Examples 1-1 to 1-9

Backsheets for solar cell were produced using the first thermoplastic resin composition, second thermoplastic resin composition, third thermoplastic resin composition and fourth resin layer (back surface protective layer) forming film in the same manner as those in Example 1-1. Various evaluations were conducted for the backsheets for solar cell. The results are shown in Tables 4 to 8.
Table 4

| | | | | Example 1-1 | Example 1-2 | Example 1-3 | Example 1-4 |
|---|---|---|---|---|---|---|---|
| Backsheet for solar cell | Layer composition | First resin layer | First thermoplastic resin composition | I-1 | I-2 | I-1 | I-1 |
| | | | Maximal Tg of thermoplastic resin (I) (°C) | 135 | 135 | 135 | 135 |
| | | | Thickness (μm) | 15 | 35 | 60 | 60 |
| | | Second resin layer | Second thermoplastic resin composition | II-1 | II-2 | II-7 | II-1 |
| | | | Maximal Tg of thermoplastic resin (II) (°C) | 155 | 155 | 155 | 155 |
| | | | Thickness (μm) | 45 | 100 | 120 | 120 |
| | | Third resin layer | Third thermoplastic resin composition | III-1 | III-1 | III-1 | III-6 |
| | | | Maximal Tg of thermoplastic resin (III) (°C) | 135 | 135 | 135 | 135 |
| | | | Thickness (μm) | 15 | 35 | 60 | 60 |
| | | Adhesive layer | Material | Polyurethane | Polyurethane | Polyurethane | Polyurethane |
| | | | Thickness (μm) | 8 | 8 | 8 | 8 |
| | | Fourth resin layer | Back surface protective layer forming film | IV-1 | IV-1 | IV-1 | IV-1 |
| | | | Thickness (μm) | 75 | 75 | 75 | 75 |
| | Thickness of backsheet for solar cell (μm) | | | 158 | 253 | 323 | 323 |
| | Evaluation | Difference between Tg of second resin layer and Tg of first resin layer (°C) | | 20 | 20 | 20 | 20 |
| | | Difference between Tg of second resin layer and Tg of third resin layer (°C) | | 20 | 20 | 20 | 20 |
| | | Thickness ratio of first resin layer and third resin layer | | 1.00 | 1.00 | 1.00 | 1.00 |
| | | {(Thickness of first resin layer) + (thickness of third resin layer)} / (Thickness of second resin layer) | | 0.67 | 0.70 | 1.00 | 1.00 |
| | | Average absorbance of light having wavelength of 400-700nm (%) | | 88 | 92 | 90 | 92 |
| | | Average reflectance against light having wavelength of 800-1400nm (%) | | 69 | 77 | 65 | 67 |
| | | L value at surface of first resin layer | | 25 | 14 | 8 | 9 |
| | | L value at surface of fourth resin layer | | 80 | 87 | 81 | 76 |
| | | Heat resistance | Dimension change ratio (%) | 0.8 | 0.5 | 0.5 | 0.5 |
| | | | Deformation state | 1 | 1 | 1 | 1 |
| | | Flexibility (Bending test) | | 1 | 1 | 1 | 1 |
| | | Hydrolysis resistance | Retention of rupture stress | 1 | 1 | 1 | 1 |
| | | | Deformation state | 1 | 1 | 1 | 1 |
| | | Improvement rate of photoelectric conversion efficiency (%) | | 8 | 11 | 7 | 7 |
| | | Heat storage property (°C) | | 45 | 51 | 53 | 52 |
| | | Weather resistance | | 1 | 1 | 1 | 1 |
| | | Flame resistance | | 1 | 1 | 1 | 1 |
| | | Scratch resistance | | 1 | 1 | 1 | 1 |

Table 5

| | | | | Example | | | |
|---|---|---|---|---|---|---|---|
| | | | | 1-5 | 1-6 | 1-7 | 1-8 |
| Backsheet for solar cell | Layer composition | First resin layer | First thermoplastic resin composition | I-3 | I-4 | I-5 | I-6 |
| | | | Maximal Tg of thermoplastic resin (I) (°C) | 135 | 135 | 135 | 135 |
| | | | Thickness (µm) | 10 | 80 | 35 | 30 |
| | | Second resin layer | Second thermoplastic resin composition | II-3 | II-4 | II-5 | II-6 |
| | | | Maximal Tg of thermoplastic resin (II) (°C) | 155 | 155 | 155 | 155 |
| | | | Thickness (µm) | 30 | 150 | 100 | 90 |
| | | Third resin layer | Third thermoplastic resin composition | III-2 | III-3 | III-4 | III-5 |
| | | | Maximal Tg of thermoplastic resin (III) (°C) | 135 | 135 | 135 | 135 |
| | | | Thickness (µm) | 10 | 80 | 35 | 30 |
| | | Adhesive layer | Material | Polyurethane | Polyurethane | Polyurethane | Polyurethane |
| | | | Thickness (µm) | 5 | 5 | 8 | 5 |
| | | Fourth resin layer | Back surface protective layer forming film | IV-2 | IV-3 | IV-2 | IV-3 |
| | | | Thickness (µm) | 75 | 50 | 75 | 50 |
| | Thickness of backsheet for solar cell (µm) | | | 130 | 365 | 253 | 205 |
| | Evaluation | Difference between Tg of second resin layer and Tg of first resin layer (°C) | | 20 | 20 | 20 | 20 |
| | | Difference between Tg of second resin layer and Tg of third resin layer (°C) | | 20 | 20 | 20 | 20 |
| | | Thickness ratio of first resin layer and third resin layer | | 1.00 | 1.00 | 1.00 | 1.00 |
| | | {(Thickness of first resin layer) + (thickness of third resin layer)} / (Thickness of second resin layer) | | 0.67 | 1.07 | 0.70 | 0.67 |
| | | Average absorbance of light having wavelength of 400-700nm (%) | | 75 | 93 | 91 | 91 |
| | | Average reflectance against light having wavelength of 800-1400nm (%) | | 53 | 87 | 79 | 75 |
| | | L value at surface of first resin layer | | 21 | 9 | 15 | 15 |
| | | L value at surface of fourth resin layer | | 76 | 89 | 86 | 86 |
| | | Heat resistance | Dimension change ratio (%) | 0.9 | 0.5 | 0.5 | 0.6 |
| | | | Deformation state | 1 | 1 | 1 | 1 |
| | | Flexibility (Bending test) | | 1 | 1 | 1 | 1 |
| | | Hydrolysis resistance | Retention of rupture stress | 1 | 1 | 1 | 1 |
| | | | Deformation state | 1 | 1 | 1 | 1 |
| | | Improvement rate of photoelectric conversion efficiency (%) | | 5 | 13 | 11 | 10 |
| | | Heat storage property (°C) | | 43 | 55 | 53 | 52 |
| | | Weather resistance | | 1 | 1 | 1 | - |
| | | Flame resistance | | 1 | 1 | 1 | 1 |
| | | Scratch resistance | | 1 | 1 | 1 | 1 |

Table 6

| | | | | Example | | Comparative Example | |
|---|---|---|---|---|---|---|---|
| | | | | 1-9 | 1-10 | 1-1 | 1-2 |
| Backsheet for solar cell | Layer composition | First resin layer | First thermoplastic resin composition | I-2 | I-2 | I-2 | I-7 |
| | | | Maximal Tg of thermoplastic resin (I) (°C) | 135 | 135 | 135 | 135 |
| | | | Thickness (μm) | 40 | 35 | 35 | 35 |
| | | Second resin layer | Second thermoplastic resin composition | II-1 | II-1 | II-2 | II-2 |
| | | | Maximal Tg of thermoplastic resin (II) (°C) | 155 | 155 | 155 | 155 |
| | | | Thickness (μm) | 110 | 100 | 100 | 100 |
| | | Third resin layer | Third thermoplastic resin composition | III-2 | III-2 | III-1 | III-1 |
| | | | Maximal Tg of thermoplastic resin (III) (°C) | 135 | 135 | 135 | 135 |
| | | | Thickness (μm) | 40 | 30 | 35 | 35 |
| | | Adhesive layer | Material | Polyurethane | Polyurethane | - | Polyurethane |
| | | | Thickness (μm) | 5 | 5 | | 8 |
| | | Fourth resin layer | Back surface protective layer forming film | IV-1 | IV-1 | | IV-1 |
| | | | Thickness (μm) | 75 | 75 | | 75 |
| | Thickness of backsheet for solar cell (μm) | | | 270 | 245 | 170 | 253 |
| | Evaluation | Difference between Tg of second resin layer and Tg of first resin layer (°C) | | 20 | 20 | 20 | 20 |
| | | Difference between Tg of second resin layer and Tg of third resin layer (°C) | | 20 | 20 | 20 | 20 |
| | | Thickness ratio of first resin layer and third resin layer | | 1.00 | 1.17 | 1.00 | 1.00 |
| | | {(Thickness of first resin layer) + (thickness of third resin layer)} / (Thickness of second resin layer) | | 0.73 | 0.65 | 0.70 | 0.70 |
| | | Average absorbance of light having wavelength of 400-700nm (%) | | 92 | 92 | 91 | 92 |
| | | Average reflectance against light having wavelength of 800-1400nm (%) | | 80 | 78 | 78 | 5 |
| | | L value at surface of first resin layer | | 13 | 14 | 15 | 12 |
| | | L value at surface of fourth resin layer | | 89 | 87 | 89 | 85 |
| | | Heat resistance | Dimension change ratio (%) | 0.5 | 0.5 | 0.4 | 0.5 |
| | | | Deformation state | 1 | 1 | 1 | 1 |
| | | Flexibility (Bending test) | | 1 | 1 | 1 | 1 |
| | | Hydrolysis resistance | Retention of rupture stress | 1 | 1 | 1 | 1 |
| | | | Deformation state | 1 | 1 | 1 | 1 |
| | | Improvement rate of photoelectric conversion efficiency (%) | | 11 | 11 | 11 | 0 |
| | | Heat storage property (°C) | | 53 | 53 | 52 | 82 |
| | | Weather resistance | | 1 | 1 | 1 | 1 |
| | | Flame resistance | | 1 | 1 | 2 | 1 |
| | | Scratch resistance | | 1 | 1 | 2 | 1 |

Table 7

| | | | | Comparative Example | | | |
|---|---|---|---|---|---|---|---|
| | | | | 1-3 | 1-4 | 1-5 | 1-6 |
| Backsheet for solar cell | Layer composition | First resin layer | First thermoplastic resin composition | I-2 | I-2 | | I-2 |
| | | | Maximal Tg of thermoplastic resin (I) (°C) | 135 | 135 | | 135 |
| | | | Thickness (μm) | 35 | 100 | | 50 |
| | | Second resin layer | Second thermoplastic resin composition | II-7 | | II-1 | II-2 |
| | | | Maximal Tg of thermoplastic resin (II) (°C) | 155 | | 155 | 155 |
| | | | Thickness (μm) | 100 | | 120 | 150 |
| | | Third resin layer | Third thermoplastic resin composition | III-6 | III-6 | | III-1 |
| | | | Maximal Tg of thermoplastic resin (III) (°C) | 135 | 135 | | 135 |
| | | | Thickness (μm) | 35 | 100 | | 100 |
| | | Adhesive layer | Material | Polyurethane | Polyurethane | Polyurethane | Polyurethane |
| | | | Thickness (μm) | 8 | 8 | 8 | 8 |
| | | Fourth resin layer | Back surface protective layer forming film | IV-1 | IV-1 | IV-1 | IV-1 |
| | | | Thickness (μm) | 75 | 75 | 75 | 75 |
| | Thickness of backsheet for solar cell (μm) | | | 253 | 283 | 203 | 383 |
| | Evaluation | Difference between Tg of second resin layer and Tg of first resin layer (°C) | | 20 | - | - | 20 |
| | | Difference between Tg of second resin layer and Tg of third resin layer (°C) | | 20 | - | - | 20 |
| | | Thickness ratio of first resin layer and third resin layer | | 1.00 | 1.00 | — | 0.50 |
| | | {(Thickness of first resin layer) + (thickness of third resin layer)} / (Thickness of second resin layer) | | 0.70 | — | 0.00 | 1.00 |
| | | Average absorbance of light having wavelength of 400-700nm (%) | | 92 | 93 | 5 | 91 |
| | | Average reflectance against light having wavelength of 800-1400nm (%) | | 3 | 75 | 75 | 85 |
| | | L value at surface of first resin layer | | 14 | 9 | 92 | 13 |
| | | L value at surface of fourth resin layer | | 45 | 43 | 87 | 92 |
| | | Heat resistance | Dimension change ratio (%) | 0.5 | 1.9 | 0.4 | 0.6 |
| | | | Deformation state | 1 | 3 | 1 | 3 |
| | | Flexibility (Bending test) | | 1 | 1 | 3 | 1 |
| | | Hydrolysis resistance | Retention of rupture stress | 1 | 1 | 1 | 1 |
| | | | Deformation state | 1 | 1 | 1 | 3 |
| | | Improvement rate of photoelectric conversion efficiency (%) | | 2 | 11 | 11 | 12 |
| | | Heat storage property (°C) | | 51 | 51 | 40 | 51 |
| | | Weather resistance | | 1 | 1 | 1 | 1 |
| | | Flame resistance | | 1 | 1 | 1 | 1 |
| | | Scratch resistance | | 1 | 1 | 1 | 1 |

Comparative Example 1-3 was an example of a backsheet for solar cell in which the second resin layer was not a white-based resin layer, the improvement rate of the photoelectric conversion efficiency was low as 2%.

Table 8

| | | | | Comparative Example | | |
|---|---|---|---|---|---|---|
| | | | | 1-7 | 1-8 | 1-9 |
| Backsheet for solar cell | Layer composition | First resin layer | First thermoplastic resin composition | I-2 | I-2 | I-2 |
| | | | Maximal Tg of thermoplastic resin (I) (°C) | 135 | 135 | 135 |
| | | | Thickness (μm) | 80 | 35 | 40 |
| | | Second resin layer | Second thermoplastic resin composition | II-2 | II-2 | II-2 |
| | | | Maximal Tg of thermoplastic resin (II) (°C) | 155 | 155 | 155 |
| | | | Thickness (μm) | 120 | 210 | 30 |
| | | Third resin layer | Third thermoplastic resin composition | III-1 | III-1 | III-1 |
| | | | Maximal Tg of thermoplastic resin (III) (°C) | 135 | 135 | 135 |
| | | | Thickness (μm) | 50 | 35 | 40 |
| | | Adhesive layer | Material | Polyurethane | Polyurethane | Polyurethane |
| | | | Thickness (μm) | 8 | 8 | 8 |
| | | Fourth resin layer | Back surface protective layer forming film | IV-1 | IV-1 | IV-1 |
| | | | Thickness (μm) | 75 | 75 | 75 |
| | Thickness of backsheet for solar cell (μm) | | | 333 | 363 | 193 |
| | Evaluation | Difference between Tg of second resin layer and Tg of first resin layer (°C) | | 20 | 20 | 20 |
| | | Difference between Tg of second resin layer and Tg of third resin layer (°C) | | 20 | 20 | 20 |
| | | Thickness ratio of first resin layer and third resin layer | | 1.60 | 1.00 | 1.00 |
| | | {(Thickness of first resin layer) + (thickness of third resin layer)} / (Thickness of second resin layer) | | 1.08 | 0.33 | 2.67 |
| | | Average absorbance of light having wavelength of 400-700nm (%) | | 93 | 90 | 91 |
| | | Average reflectance against light having wavelength of 800-1400nm (%) | | 79 | 83 | 70 |
| | | L value at surface of first resin layer | | 12 | 14 | 13 |
| | | L value at surface of fourth resin layer | | 87 | 90 | 81 |
| | | Heat resistance | Dimension change ratio (%) | 0.9 | 0.4 | 1.4 |
| | | | Deformation state | 3 | 1 | 1 |
| | | Flexibility (Bending test) | | 1 | 3 | 1 |
| | | Hydrolysis resistance | Retention of rupture stress | 1 | 1 | 1 |
| | | | Deformation state | 3 | 1 | 1 |
| | | Improvement rate of photoelectric conversion efficiency (%) | | 11 | 12 | 10 |
| | | Heat storage property (°C) | | 51 | 52 | 51 |
| | | Weather resistance | | 1 | 1 | 1 |
| | | Flame resistance | | 1 | 1 | 1 |
| | | Scratch resistance | | 1 | 1 | 1 |

7. Production and evaluation of backsheet for solar cell (2) Example 2-1

A multi-layer type film forming machine provided with three extruders each comprising a T-die having a die width of 1,400 mm and a lip distance of 1.5 mm, and a screw of 65 mm diameter was used, and the first thermoplastic resin composition (I-1), second thermoplastic resin composition (II-1) and third thermoplastic resin composition (III-1) were supplied to the extruders. Then, the molten resins were discharged from the T-dies at a temperature of 270°C, respectively, to form a three-layer type soft film. After that, this three-layer type soft film was cooled and solidified while being surface-contacted, by air knife, to a cast roll having a surface temperature controlled to be 95°C, to form a laminated film having a thickness of 75 μm. The thickness of the first resin layer, second resin layer and third resin layer were shown in Table 9. The thickness of the film was measured with a thickness gauge "ID-C1112C" (type name) manufactured by Mitutoyo Corp. and was an average value of those measured values which was obtained by once cutting a film piece out of the produced film after a lapse of one hour from commencement of production thereof, and by measuring thicknesses of the film piece at its widthwise center and at points (n=107) at intervals of 10 mm from the widthwise center toward both edges. The values at measured points within a range of 20 mm from each edge of the film piece were excluded from the calculation of the average value.
Subsequently, a water vapor barrier layer forming film (R-1) was adhered with a polyurethane-based adhesive onto a surface of the laminated film such that a vapor deposited film thereof was brought to an outer surface side. Further, a fourth resin layer (back surface protective layer) forming film (IV-1) was adhered with a polyurethane-based adhesive onto a surface of the vapor deposited film of the water vapor barrier layer to obtain a backsheet for solar cell. Various evaluations were conducted for the backsheet for solar cell. The results are shown in Table 9.

Examples 2-2 to 2-10 and Comparative Examples 2-1 to 2-9

Backsheets for solar cell were produced using the first thermoplastic resin composition, second thermoplastic resin composition, third thermoplastic resin composition, water vapor barrier layer forming film and fourth resin layer (back surface protective layer) forming film in the same manner as those in Example 2-1. Various evaluations were conducted for the backsheets for solar cell. The results are shown in Tables 9 to 13.
Table 9

| | | | Example 2-1 | Example 2-2 | Example 2-3 | Example 2-4 |
|---|---|---|---|---|---|---|
| Backsheet for solar cell – Layer composition | First resin layer | First thermoplastic resin composition | I-1 | I-2 | I-1 | I-1 |
| | | Maximal Tg of thermoplastic resin (I) (°C) | 135 | 135 | 135 | 135 |
| | | Thickness (μm) | 15 | 35 | 60 | 60 |
| | Second resin layer | Second thermoplastic resin composition | II-1 | II-2 | II-7 | II-1 |
| | | Maximal Tg of thermoplastic resin (II) (°C) | 155 | 155 | 155 | 155 |
| | | Thickness (μm) | 45 | 100 | 120 | 120 |
| | Third resin layer | Third thermoplastic resin composition | III-1 | III-1 | III-1 | III-6 |
| | | Maximal Tg of thermoplastic resin (III) (°C) | 135 | 135 | 135 | 135 |
| | | Thickness (μm) | 15 | 35 | 60 | 60 |
| | Adhesive layer | Material | Polyurethane | Polyurethane | Polyurethane | Polyurethane |
| | | Thickness (μm) | 8 | 8 | 8 | 8 |
| | Water vapor barrier layer | Water vapor barrier layer forming film | R-1 | R-1 | R-1 | R-1 |
| | | Thickness (μm) | 12 | 12 | 12 | 12 |
| | Adhesive layer | Material | Polyurethane | Polyurethane | Polyurethane | Polyurethane |
| | | Thickness (μm) | 8 | 8 | 8 | 8 |
| | Fourth resin layer | Back surface protective layer forming film | IV-1 | IV-1 | IV-1 | IV-1 |
| | | Thickness (μm) | 75 | 75 | 75 | 75 |
| Thickness of backsheet for solar cell (μm) | | | 178 | 273 | 343 | 343 |
| Evaluation | Difference between Tg of second resin layer and Tg of first resin layer (°C) | | 20 | 20 | 20 | 20 |
| | Difference between Tg of second resin layer and Tg of third resin layer (°C) | | 20 | 20 | 20 | 20 |
| | Thickness ratio of first resin layer and third resin layer | | 1.00 | 1.00 | 1.00 | 1.00 |
| | {(Thickness of first resin layer) + (thickness of third resin layer)} / (Thickness of second resin layer) | | 0.67 | 0.70 | 1.00 | 1.00 |
| | Average absorbance of light having wavelength of 400-700nm (%) | | 88 | 92 | 90 | 92 |
| | Average reflectance against light having wavelength of 800-1400nm (%) | | 69 | 77 | 65 | 67 |
| | L value at surface of first resin layer | | 25 | 14 | 8 | 9 |
| | L value at surface of fourth resin layer | | 80 | 87 | 81 | 76 |
| | Heat resistance | Dimension change ratio (%) | 0.8 | 0.5 | 0.5 | 0.5 |
| | | Deformation state | 1 | 1 | 1 | 1 |
| | Flexibility (Bending test) | | 1 | 1 | 1 | 1 |
| | Hydrolysis resistance | Retention of rupture stress | 2 | 1 | 1 | 1 |
| | | Deformation state | 1 | 1 | 1 | 1 |
| | Improvement rate of photoelectric conversion efficiency (%) | | 8 | 11 | 7 | 7 |
| | Heat storage property (°C) | | 45 | 51 | 53 | 52 |
| | Weather resistance | | 1 | 1 | 1 | 1 |
| | Flame resistance | | 1 | 1 | 1 | 1 |
| | Water vapor barrier property (g/(m²·day)) | | 0.5 | 0.3 | 0.3 | 0.3 |
| | Scratch resistance | | 1 | 1 | 1 | 1 |

Table 10

| | | | | Example 2-5 | Example 2-6 | Example 2-7 | Example 2-8 |
|---|---|---|---|---|---|---|---|
| Backsheet for solar cell | Layer composition | First resin layer | First thermoplastic resin composition | I-3 | I-4 | I-5 | I-6 |
| | | | Maximal Tg of thermoplastic resin (I) (°C) | 135 | 135 | 135 | 135 |
| | | | Thickness (μm) | 10 | 80 | 35 | 30 |
| | | Second resin layer | Second thermoplastic resin composition | II-3 | II-4 | II-5 | II-6 |
| | | | Maximal Tg of thermoplastic resin (II) (°C) | 155 | 155 | 155 | 155 |
| | | | Thickness (μm) | 30 | 150 | 100 | 90 |
| | | Third resin layer | Third thermoplastic resin composition | III-2 | III-3 | III-4 | III-5 |
| | | | Maximal Tg of thermoplastic resin (III) (°C) | 135 | 135 | 135 | 135 |
| | | | Thickness (μm) | 10 | 80 | 35 | 30 |
| | | Adhesive layer | Material | Polyurethane | Polyurethane | Polyurethane | Polyurethane |
| | | | Thickness (μm) | 5 | 5 | 3 | 5 |
| | | Water vapor barrier layer | Water vapor barrier layer forming film | R-2 | R-2 | R-1 | R-1 |
| | | | Thickness (μm) | 12 | 12 | 12 | 12 |
| | | Adhesive layer | Material | Polyurethane | Polyurethane | Polyurethane | Polyurethane |
| | | | Thickness (μm) | 5 | 5 | 8 | 5 |
| | | Fourth resin layer | Back surface protective layer forming film | IV-2 | IV-3 | IV-2 | IV-3 |
| | | | Thickness (μm) | 75 | 50 | 75 | 50 |
| | Thickness of backsheet for solar cell (μm) | | | 147 | 382 | 268 | 222 |
| | Evaluation | Difference between Tg of second resin layer and Tg of first resin layer (°C) | | 20 | 20 | 20 | 20 |
| | | Difference between Tg of second resin layer and Tg of third resin layer (°C) | | 20 | 20 | 20 | 20 |
| | | Thickness ratio of first resin layer and third resin layer | | 1.00 | 1.00 | 1.00 | 1.00 |
| | | {(Thickness of first resin layer) + (thickness of third resin layer)} / (Thickness of second resin layer) | | 0.67 | 1.07 | 0.70 | 0.67 |
| | | Average absorbance of light having wavelength of 400-700nm (%) | | 75 | 93 | 91 | 91 |
| | | Average reflectance against light having wavelength of 800-1400nm (%) | | 53 | 87 | 79 | 75 |
| | | L value at surface of first resin layer | | 21 | 9 | 15 | 15 |
| | | L value at surface of fourth resin layer | | 76 | 89 | 86 | 86 |
| | | Heat resistance | Dimension change ratio (%) | 0.9 | 0.5 | 0.5 | 0.6 |
| | | | Deformation state | 2 | 1 | 1 | 1 |
| | | Flexibility (Bending test) | | 1 | 1 | 1 | 1 |
| | | Hydrolysis resistance | Retention of rupture stress | 2 | 1 | 1 | 1 |
| | | | Deformation state | 2 | 1 | 1 | 1 |
| | | Improvement rate of photoelectric conversion efficiency (%) | | 5 | 13 | 11 | 10 |
| | | Heat storage property (°C) | | 43 | 55 | 53 | 52 |
| | | Weather resistance | | 1 | 1 | 1 | 2 |
| | | Flame resistance | | 1 | 1 | 1 | 1 |
| | | Water vapor barrier property (g/(m²·day)) | | 0.3 | 0.4 | 0.4 | 0.4 |
| | | Scratch resistance | | 1 | 1 | 1 | 1 |

Table 11

| | | | | Example | | Comparative Example | |
|---|---|---|---|---|---|---|---|
| | | | | 2-9 | 2-10 | 2-1 | 2-2 |
| Backsheet for solar cell | Layer composition | First resin layer | First thermoplastic resin composition | I-2 | I-2 | I-2 | I-7 |
| | | | Maximal Tg of thermoplastic resin (I) (°C) | 135 | 135 | 135 | 135 |
| | | | Thickness (μm) | 40 | 35 | 35 | 35 |
| | | Second resin layer | Second thermoplastic resin composition | II-1 | II-1 | II-2 | II-2 |
| | | | Maximal Tg of thermoplastic resin (II) (°C) | 155 | 155 | 155 | 155 |
| | | | Thickness (μm) | 110 | 100 | 100 | 100 |
| | | Third resin layer | Third thermoplastic resin composition | III-2 | III-2 | III-1 | III-1 |
| | | | Maximal Tg of thermoplastic resin (III) (°C) | 135 | 135 | 135 | 135 |
| | | | Thickness (μm) | 40 | 30 | 35 | 35 |
| | | Adhesive layer | Material | Polyurethane | Polyurethane | Polyurethane | Polyurethane |
| | | | Thickness (μm) | 5 | 5 | 8 | 8 |
| | | Water vapor barrier layer | Water vapor barrier layer forming film | R-1 | R-1 | R-1 | R-2 |
| | | | Thickness (μm) | 12 | 12 | 12 | 12 |
| | | Adhesive layer | Material | Polyurethane | Polyurethane | | Polyurethane |
| | | | Thickness (μm) | 5 | 5 | | 8 |
| | | Fourth resin layer | Back surface protective layer forming film | IV-1 | IV-1 | | IV-1 |
| | | | Thickness (μm) | 75 | 75 | | 75 |
| | Thickness of backsheet for solar cell (μm) | | | 287 | 262 | 190 | 273 |
| | Evaluation | Difference between Tg of second resin layer and Tg of first resin layer (°C) | | 20 | 20 | 20 | 20 |
| | | Difference between Tg of second resin layer and Tg of third resin layer (°C) | | 20 | 20 | 20 | 20 |
| | | Thickness ratio of first resin layer and third resin layer | | 1.00 | 1.17 | 1.00 | 1.00 |
| | | {(Thickness of first resin layer) + (thickness of third resin layer)} / (Thickness of second resin layer) | | 0.73 | 0.65 | 0.70 | 0.70 |
| | | Average absorbance of light having wavelength of 400-700nm (%) | | 92 | 92 | 91 | 92 |
| | | Average reflectance against light having wavelength of 800-1400nm (%) | | 80 | 78 | 78 | 5 |
| | | L value at surface of first resin layer | | 13 | 14 | 15 | 12 |
| | | L value at surface of fourth resin layer | | 89 | 87 | 89 | 85 |
| | | Heat resistance | Dimension change ratio (%) | 0.5 | 0.5 | 0.4 | 0.5 |
| | | | Deformation state | 1 | 1 | 1 | 1 |
| | | Flexibility (Bending test) | | 1 | 1 | 1 | 1 |
| | | Hydrolysis resistance | Retention of rupture stress | 1 | 1 | 1 | 1 |
| | | | Deformation state | 1 | 1 | 1 | 1 |
| | | Improvement rate of photoelectric conversion efficiency (%) | | 11 | 11 | 11 | 0 |
| | | Heat storage property (°C) | | 53 | 53 | 52 | 82 |
| | | Weather resistance | | 1 | 1 | 1 | 1 |
| | | Flame resistance | | 1 | 1 | 2 | 1 |
| | | Water vapor barrier property (g/(m$^2$·day)) | | 0.4 | 0.3 | 0.5 | 0.5 |
| | | Scratch resistance | | 1 | 1 | 2 | 1 |

Table 12

| | | | Comparative Example 2-3 | Comparative Example 2-4 | Comparative Example 2-5 | Comparative Example 2-6 |
|---|---|---|---|---|---|---|
| Backsheet for solar cell / Layer composition | First resin layer | First thermoplastic resin composition | I-2 | I-2 | | I-2 |
| | First resin layer | Maximal Tg of thermoplastic resin (I) (°C) | 135 | 135 | | 135 |
| | First resin layer | Thickness (μm) | 35 | 100 | | 50 |
| | Second resin layer | Second thermoplastic resin composition | II-7 | | II-1 | II-2 |
| | Second resin layer | Maximal Tg of thermoplastic resin (II) (°C) | 155 | | 155 | 155 |
| | Second resin layer | Thickness (μm) | 100 | | 120 | 150 |
| | Third resin layer | Third thermoplastic resin composition | III-6 | III-6 | | III-1 |
| | Third resin layer | Maximal Tg of thermoplastic resin (III) (°C) | 135 | 135 | | 135 |
| | Third resin layer | Thickness (μm) | 35 | 100 | | 100 |
| | Adhesive layer | Material | Polyurethane | Polyurethane | Polyurethane | Polyurethane |
| | Adhesive layer | Thickness (μm) | 8 | 8 | 8 | 8 |
| | Water vapor barrier layer | Water vapor barrier layer forming film | R-1 | R-1 | R-1 | R-1 |
| | Water vapor barrier layer | Thickness (μm) | 12 | 12 | 12 | 12 |
| | Adhesive layer | Material | Polyurethane | Polyurethane | Polyurethane | Polyurethane |
| | Adhesive layer | Thickness (μm) | 8 | 8 | 8 | 8 |
| | Fourth resin layer | Back surface protective layer forming film | IV-1 | IV-1 | IV-1 | IV-1 |
| | Fourth resin layer | Thickness (μm) | 75 | 75 | 75 | 75 |
| Backsheet for solar cell | Thickness of backsheet for solar cell (μm) | | 273 | 303 | 223 | 403 |
| Backsheet for solar cell / Evaluation | Difference between Tg of second resin layer and Tg of first resin layer (°C) | | 20 | - | - | 20 |
| | Difference between Tg of second resin layer and Tg of third resin layer (°C) | | 20 | - | - | 20 |
| | Thickness ratio of first resin layer and third resin layer | | 1.00 | 1.00 | — | 0.50 |
| | {(Thickness of first resin layer) + (thickness of third resin layer)} / (Thickness of second resin layer) | | 0.70 | — | 0.00 | 1.00 |
| | Average absorbance of light having wavelength of 400-700nm (%) | | 92 | 93 | 5 | 91 |
| | Average reflectance against light having wavelength of 800-1400nm (%) | | 3 | 75 | 75 | 85 |
| | L value at surface of first resin layer | | 14 | 9 | 92 | 13 |
| | L value at surface of fourth resin layer | | 45 | 43 | 87 | 92 |
| | Heat resistance | Dimension change ratio (%) | 0.5 | 1.9 | 0.4 | 0.6 |
| | Heat resistance | Deformation state | 1 | 3 | 1 | 3 |
| | Flexibility (Bending test) | | 1 | 1 | 3 | 1 |
| | Hydrolysis resistance | Retention of rupture stress | 1 | 1 | 1 | 1 |
| | Hydrolysis resistance | Deformation state | 1 | 1 | 1 | 3 |
| | Improvement rate of photoelectric conversion efficiency (%) | | 2 | 11 | 11 | 12 |
| | Heat storage property (°C) | | 51 | 51 | 40 | 51 |
| | Weather resistance | | 1 | 1 | 1 | 1 |
| | Flame resistance | | 1 | 1 | 1 | 1 |
| | Water vapor barrier property (g/($m^2$·day)) | | 0.3 | 0.3 | 0.3 | 0.3 |
| | Scratch resistance | | 1 | 1 | 1 | 1 |

Comparative Example 2-3 was an example of a backsheet for solar cell in which the second resin layer was not a white-based resin layer, the improvement rate of the photoelectric conversion efficiency improvement was low as 2%.

Table 13

| | | | | Comparative Example | | |
|---|---|---|---|---|---|---|
| | | | | 2-7 | 2-8 | 2-9 |
| Backsheet for solar cell | Layer composition | First resin layer | First thermoplastic resin composition | I-2 | I-2 | I-2 |
| | | | Maximal Tg of thermoplastic resin (I) (°C) | 135 | 135 | 135 |
| | | | Thickness (μm) | 80 | 35 | 40 |
| | | Second resin layer | Second thermoplastic resin composition | II-2 | II-2 | II-2 |
| | | | Maximal Tg of thermoplastic resin (II) (°C) | 155 | 155 | 155 |
| | | | Thickness (μm) | 120 | 210 | 30 |
| | | Third resin layer | Third thermoplastic resin composition | III-1 | III-1 | III-1 |
| | | | Maximal Tg of thermoplastic resin (III) (°C) | 135 | 135 | 135 |
| | | | Thickness (μm) | 50 | 35 | 40 |
| | | Adhesive layer | Material | Polyurethane | Polyurethane | Polyurethane |
| | | | Thickness (μm) | 8 | 8 | 8 |
| | | Water vapor barrier layer | Water vapor barrier layer forming film | R-1 | R-1 | R-1 |
| | | | Thickness (μm) | 12 | 12 | 12 |
| | | Adhesive layer | Material | Polyurethane | Polyurethane | Polyurethane |
| | | | Thickness (μm) | 8 | 8 | 8 |
| | | Fourth resin layer | Back surface protective layer forming film | IV-1 | IV-1 | IV-1 |
| | | | Thickness (μm) | 75 | 75 | 75 |
| | Thickness of backsheet for solar cell (μm) | | | 353 | 383 | 213 |
| | Evaluation | Difference between Tg of second resin layer and Tg of first resin layer (°C) | | 20 | 20 | 20 |
| | | Difference between Tg of second resin layer and Tg of third resin layer (°C) | | 20 | 20 | 20 |
| | | Thickness ratio of first resin layer and third resin layer | | 1.60 | 1.00 | 1.00 |
| | | {(Thickness of first resin layer) + (thickness of third resin layer)} / (Thickness of second resin layer) | | 1.08 | 0.33 | 2.67 |
| | | Average absorbance of light having wavelength of 400-700nm (%) | | 93 | 90 | 91 |
| | | Average reflectance against light having wavelength of 800-1400nm (%) | | 79 | 83 | 70 |
| | | L value at surface of first resin layer | | 12 | 14 | 13 |
| | | L value at surface of fourth resin layer | | 87 | 90 | 81 |
| | | Heat resistance | Dimension change ratio (%) | 0.9 | 0.4 | 1.4 |
| | | | Deformation state | 3 | 1 | 1 |
| | | Flexibility (Bending test) | | 1 | 3 | 1 |
| | | Hydrolysis resistance | Retention of rupture stress | 1 | 1 | 1 |
| | | | Deformation state | 3 | 1 | 1 |
| | | Improvement rate of photoelectric conversion efficiency (%) | | 11 | 12 | 10 |
| | | Heat storage property (°C) | | 51 | 52 | 51 |
| | | Weather resistance | | 1 | 1 | 1 |
| | | Flame resistance | | 1 | 1 | 1 |
| | | Water vapor barrier property (g/($m^2$·day)) | | 0.3 | 0.3 | 0.3 |
| | | Scratch resistance | | 1 | 1 | 1 |

[Industrial Applicability]

The backsheet of the present invention is capable of improving a power generation efficiency of a solar cell, is excellent in design, heat resistance, flexibility, dimension stability and weather resistance, and is further excellent in scratch resistance, penetration resistance, chemical resistance and flame resistance. Thus, the backsheet is suitable for outdoor usage where the backsheet is exposed to sunlight, wind and rain, and the like over a long period of time, and the backsheet is useful as one not only for solar cell module constituting a solar cell to be used on a roof of a house or the like, but also for solar cell module, which is to have a resiliency.

[Explanations of numerals]

| | |
|---|---|
| 1, 1A and 1B: | backsheet for solar cell |
| 11: | first resin layer (infrared transmissible colored resin layer) |
| 12: | second resin layer (white-based resin layer) |
| 13: | third resin layer |
| 14: | fourth resin layer (back surface protective layer) |
| 15: | water vapor barrier layer |
| 2: | solar cell module |
| 21: | obverse surface side transparent protective member |
| 23: | obverse surface side sealing film |
| 25: | solar cell element |
| 27: | reverse surface side sealing film |

**Claims**

1. A backsheet for solar cell comprising a first resin layer, a second resin layer, a third resin layer, and a fourth resin layer, sequentially, **characterized in that** said first resin layer is an infrared transmissible colored resin layer, that at least said second resin layer, of said second resin layer and said third resin layer, is a white-based resin layer, that said fourth resin layer is a back surface protective layer, and that a thickness ($H_A$) of said first resin layer, a thickness ($H_B$) of said second resin layer, and a thickness ($H_C$) of said third resin layer satisfy the following equations (1) and (2).

$$0.4 \leqq (H_A+H_C)/H_B \leqq 2.4 \qquad (1)$$

$$0.7 \leqq HA/H_C \leqq 1.3 \qquad (2)$$

2. The backsheet for solar cell according to Claim 1,
wherein a thermoplastic resin constituting said first resin layer, a thermoplastic resin constituting said second resin layer, and a thermoplastic resin constituting said third resin layer each contain an aromatic vinyl-based resin.

3. The backsheet for solar cell according to Claim 2,
wherein both a glass transition temperature of said thermoplastic resin constituting said first resin layer and a glass transition temperature of said thermoplastic resin constituting said third resin layer are lower than a glass transition temperature of said thermoplastic resin constituting said second resin layer.

4. The backsheet for solar cell according to any one of Claims 1 to 3,
wherein said backsheet has an absorbance of a light having a wavelength of 400 to 700 nm of 60% or higher when said light is irradiated to a surface of said first resin layer of said backsheet for solar cell.

5. The backsheet for solar cell according to any one of Claims 1 to 4,
wherein said backsheet has a reflectance to a light having a wavelength of 800 to 1,400 nm of 50% or higher when said light is irradiated to a surface of said first resin layer of said backsheet for solar cell.

6. The backsheet for solar cell according to any one of Claims 1 to 5,
wherein said fourth resin layer is a layer having flame resistance.

**7.** The backsheet for solar cell according to any one of Claims 1 to 6, further comprising a water vapor barrier layer between said third resin layer and said fourth resin layer.

**8.** The backsheet for solar cell according to Claim 7,
wherein said water vapor barrier layer is consisting of a vapor deposited film in which a layer of a metal and/or a metal oxide is formed thereon.

**9.** The backsheet for solar cell according to Claim 7 or 8,
wherein an adhesive layer is provided between said third resin layer and/or said fourth resin layer, and said water vapor barrier layer.

**10.** The backsheet for solar cell according to any one of Claims 1 to 9, having a dimension change ratio of $\pm$1% or less when said backsheet for solar cell is left to stand still at a temperature of 150°C for 30 minutes.

**11.** The backsheet for solar cell according to any one of Claims 1 to 10, wherein a thickness of said backsheet for solar cell is in the range from 50 to 1,000 $\mu$m.

**12.** A solar cell module, **characterized by** comprising said backsheet for solar cell according to any one of Claims 1 to 11.

FIG. 1

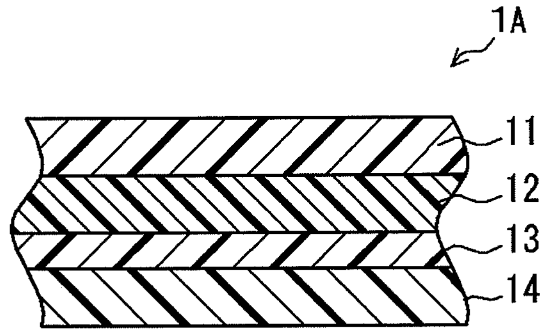


FIG. 2

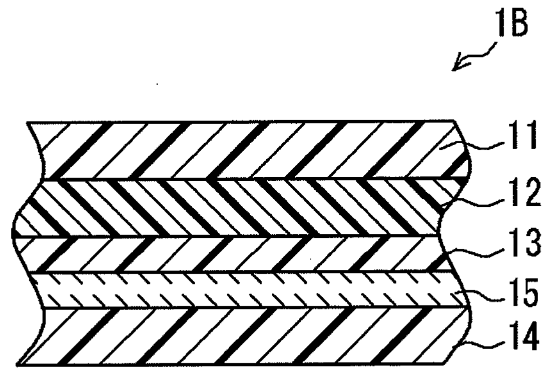


FIG. 3

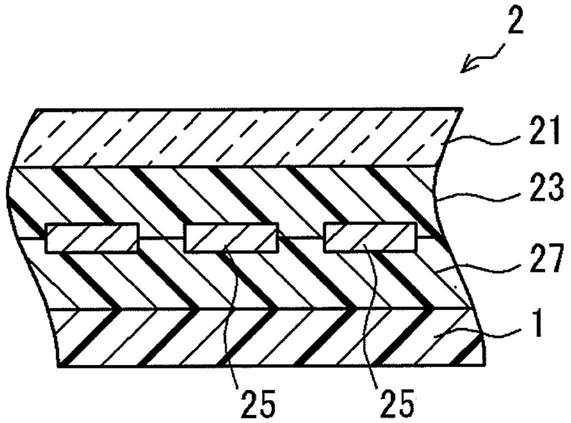

**INTERNATIONAL SEARCH REPORT**

International application No.
PCT/JP2009/070347

A. CLASSIFICATION OF SUBJECT MATTER
*H01L31/042*(2006.01)i

According to International Patent Classification (IPC) or to both national classification and IPC

B. FIELDS SEARCHED

Minimum documentation searched (classification system followed by classification symbols)
H01L31/04-31/078

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2007-208179 A (Teijin DuPont Films Japan Ltd.), 16 August 2007 (16.08.2007), paragraphs [0011] to [0054] (Family: none) | 1-12 |
| A | JP 2007-128943 A (Toray Industries, Inc.), 24 May 2007 (24.05.2007), paragraphs [0030] to [0062] (Family: none) | 1-12 |
| A | JP 2007-103813 A (Techno Polymer Co., Ltd.), 19 April 2007 (19.04.2007), paragraphs [0105] to [0140] (Family: none) | 1-12 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 25 February, 2010 (25.02.10) | 09 March, 2010 (09.03.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2009/070347

C (Continuation). DOCUMENTS CONSIDERED TO BE RELEVANT

| Category* | Citation of document, with indication, where appropriate, of the relevant passages | Relevant to claim No. |
|---|---|---|
| A | JP 2005-125700 A (Teijin DuPont Films Japan Ltd.), 19 May 2005 (19.05.2005), paragraphs [0023] to [0047] (Family: none) | 1-12 |
| P,A | JP 2009-135457 A (Techno Polymer Co., Ltd.), 18 June 2009 (18.06.2009), claims 1 to 5; paragraphs [0009], [0167] to [0169] & WO 2009/054450 A1 | 1-12 |
| P,A | WO 2009/142191 A1 (Techno Polymer Co., Ltd.), 26 November 2009 (26.11.2009), claims 1 to 3, 12 to 18; paragraphs [0157] to [0174] (Family: none) | 1-12 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006270025 A
- JP 2007177136 A
- JP 2007103813 A
- JP 2007128943 A
- US P2891920 A
- US P3294725 A
- JP H4239010 A
- JP H4100812 A